# EUROPÄISCHE PATENTANMELDUNG

(11) **EP 1 482 574 A2**
(43) Veröffentlichungstag der Anmeldung: **01.12.2004**
(21) Anmeldenummer: 04012793.8
(22) Anmeldetag: 28.05.2004
(51) Int. Cl.: H01L 51/20, H01L 27/00

(54) **Schaltungselement mit einer ersten Schicht aus einem elektrisch isolierenden Substratmaterial und Verfahren zur Herstellung eines Schaltungselements**

(30) Priorität: 28.05.2003 DE 10324388
(71) Anmelder: Infineon Technologies AG, 81669 München (DE)
(72) Erfinder: Luyken, Richard Johannes, 81825 München (DE); Schmid, Günter, 91334 Hemhofen (DE); Seitz, Markus, 81245 München (DE); Thewes, Roland, 82194 Gröbenzell (DE); Weber, Werner, 80637 München (DE)
(74) Vertreter: Viering, Jentschura & Partner

(57) **Zusammenfassung**

Das Schaltungselement weist eine erste Schicht aus einem elektrisch isolierenden Substratmaterial und einem ersten elektrisch leitfähigen Material, das als mindestens ein diskreter Bereich dergestalt ausgebildet ist, dass es in das Substratmaterial eingebettet und/oder auf dem Substratmaterial aufgebracht ist. Ferner weist es eine zweite Schicht mit einem zweiten elektrisch leitfähigen Material, und eine monomolekulare Schicht aus zum Elektronentransport befähigten Molekülen, die zwischen der ersten Schicht und der zweiten Schicht angeordnet ist, auf. Dabei weist jedes zum Transport von Ladungsträgern befähigte Molekül auf: mindestens eine redox-aktive Einheit, mindestens eine als Elektronendonator dienende Einheit und mindestens eine als Elektronenakzeptor dienende Einheit, wobei in jedem Molekül die redox-aktive Einheit jeweils zwischen der als Elektronendonator und der als Elektronenakzeptor dienenden Einheit angeordnet ist.

Bezugszeichen

- 100: Schaltungselement
- 101: Substratmaterial
- 102: Diskreter Bereich aus elektrisch leitfähigem Material
- 103: zum Transport von Ladungsträgern befähigten Moleküle
- 104: Widerstand
- 105: Diode
- 106: Schicht aus elektrisch leitfähigem Material
- 114: Ankergruppe
- 115: als Elektronendonator wirkende Einheit
- 116: als Elektronenakzeptor dienende Einheit
- 117: redox-aktive Einheit
- 118: Spacerbereich
- 119: Spacerbereiche
- 120: Spacerbereiche
- 121: Spacerbereiche
- 122: Pfeil

- 200: Crosspoint-Zelle
- 201: Wortleitung
- 202: Bitleitung
- 203: Schicht aus den elektrisch aktiven Molekülen

- 300: Schaltungselement
- 301: Substratmaterial
- 302: Bereich aus Gold
- 303: Bereich aus Gold
- 304: Bereich aus Gold
- 305: Schicht aus den elektrisch aktiven Molekülen
- 306: inerte Moleküle
- 307: zweite elektrisch leitfähige Schicht
- 308: Schicht aus Titan
- 309: Schicht aus Aluminium

- 401: Spannung
- 402: Widerstand
- 403: Kennlinie
- 404: Kennlinie
- 405: Kennlinie
- 406: Bereich
- 407: Bereich
- 408: Bereich
- 411: Di-Kation der Bispyridinium-Einheit
- 412: Schemadarstellung des Di-Kation der Bispyridinium-Einheit
- 413: einfach positiv geladenes Radikalkation
- 414: Schemadarstellung des einfach positiv geladenes Radikalkationa
- 415: Alkylketten
- 416: x-Achse
- 417: kleine positive oder negative Potentiale
- 418: zum Lesen des Speicherelements eingesetzter Bereich
- 419: größeres negatives Potential
- 420: zum Beschreiben des Speicherelements eingesetzter Bereich
- 421: größeres positives Potential
- 422: zum Löschen des Speicherelements eingesetzter Bereichs

- 501: Spannung
- 502: Strom
- 503: Kennlinie
- 504: Sperrbereich
- 505: Durchlassbereich
- 506: Durchlassbereich

- 601: Zelle des Speicherelements
- 602: Zelle des Speicherelements
- 603: Zelle des Speicherelements
- 604: Zelle des Speicherelements
- 605: Bitleitung
- 606: Wortleitung
- 607: Bitleitung
- 608: Wortleitung

- 701: Zelle des Speicherelements
- 702: Zelle des Speicherelements
- 703: Zelle des Speicherelements
- 704: Zelle des Speicherelements
- 705: Bitleitung
- 706: Wortleitung
- 707: Bitleitung
- 708: Wortleitung

- 1000: Schaltungselement
- 1002: Schicht
- 1003: Schicht

## Beschreibung

Die Erfindung betrifft ein Schaltungselement mit einer ersten Schicht aus einem elektrisch isolierenden Substratmaterial sowie ein Verfahren zur Herstellung eines Schaltungselements.

Die herkömmliche auf Silizium-Komponenten wie beispielsweise CMOS-Chips (CMOS: complementary metal-oxide-semiconductor), basierende Mikroelektronik, wird auch bei weiter fortschreitender Miniaturisierung an ihre Grenzen kommen. Als einer der möglichen Wege zur weiteren Verkleinerung von Bauelementen wird die Molekularelektronik diskutiert.

Neben der allgemeinen Problemstellung, Schaltungselemente mit Hilfe der Molekularelektronik zu entwickeln, ist ein weiterer in diesem Zusammenhang betrachteter Aspekt, die Entwicklung von Alternativen zu den bisherigen Halbleiter-Speicherelemente wie DRAMs (Dynamische Schreib-Lese-Speicher), SRAMs (Statische Schreib-Lese-Speicher) oder Flash-Speichern.

Aus [1] ist bekannt, das mit Hilfe von monomolekularen auf Rotaxanen basierenden Schichten konfigurierbare Schaltungselemente erhalten werden können, die zur Konstruktion von Logikgattern eingesetzt werden können. Grundlage hierfür ist, dass die monomolekularen Schichten der Rotaxane von einem leitfähigen in einen weniger leitfähigen durch Anlegen einer Spannung gebracht, d.h. "geschaltet", werden können. Allerdings ist dieser aus [1] bekannte Schaltvorgang irreversibel und somit nur für eine write once/read multiple Anwendung geeignet.

Aus [2] ist bekannt, dass mit Hilfe einer weiteren speziellen Molekülklasse, den sogenannten Catenanen, ein reversibler Schaltvorgang erreicht werden kann. Allerdings werden bei diesem Schaltvorgang deutlich geringere Signale beobachtet.

Die beiden aus [1] und [2] bekannten Schaltungselemente weisen jedoch noch weitere Nachteile für eine breite praktische Anwendung auf. Zum einen sind Rotaxane und Catenane nur durch aufwändige Synthesen erhältlich. Zum anderen werden bei beiden Schaltungselementen zur Erzeugung der monomolekularen Schichten Langmuir-Blodgett-Verfahren angewendet. Darüber hinaus ist die Eignung dieser Langmuir-Blodgett-Verfahren für die Beschichtung von Oberflächen von Bauelementen wie Siliziumwafer, die üblicherweise zur Herstellung elektrischer Bauelemente dienen, noch ungewiss.

Neben den eben diskutierten Ansätzen zur Entwicklung von Schaltungselementen auf Basis von organischen Molekülschichten ist aus [3] bekannt, dass sich durch die spezielle Kombination eines Moleküls mit einer Bispyridinium-Einheit und einem Nanoteilchen (Metall-Cluster) aus Gold ein elektrischer Schalter verwirklichen lässt. Da die Nanotechnologie sich noch in den Anfängen befindet, ist fraglich, ob dieses System in absehbarer Zeit für eine praktische Anwendung eingesetzt werden kann.

Weitere Entwicklungen auf dem Gebiet der Molekularelektronik sind in [4] beschrieben. Unter anderem wird in [4] ein Schaltungselement auf Basis eines speziellen substituierten 4,4'-Di(phenylen-ethynylen)-benzothiolat, das eine Ethylgruppe als Substituent an der 3-Position der Phenylen-Einheit trägt, beschrieben. Bei diesem Schaltungselement bewirkt eine temperaturabhängige konformationelle Änderung, nämlich eine Rotation der zentralen Phenylen-Einheit, eine abrupte Änderung der Leitfähigkeit bei 20K. Ein anderes Phenylen-Ethynylen-benzothiolat, das an der 4-Position der zentralen Phenylen-Einheit mit einer Nitroamin-Gruppe, die als Redox-Zentrum dient, substituiert ist, kann [4] zufolge in einem Speicherelement verwendet werden.

Eine praktische Anwendung dieser Schaltungselemente wird in [4] jedoch als nicht sicher bezeichnet. In [5] werden die in [4] diskutierten Benzothiolate lediglich als vielversprechend für Speicherelemente bezeichnet.

[40] offenbart ein Verfahren und eine Vorrichtung zum Steuern eines elektrischen Stroms durch Biomoleküle.

[41] offenbart eine Molekularelektronik-Anordnung mit zwei Leiterbahnen, die unter Verwendung eines Abstandshalters in einem definierten Abstand voneinander vorsehbar sind, wobei zwischen den beiden Leiterbahnen ein molekularelektronisches Molekül anbringbar ist.

[42] offenbart ein molekulares elektronisches Bauelement zum Aufbau nanoelektronischer Schaltungen, eine molekulare elektronische Baugruppe und eine elektronische Schaltung.

[43] offenbart eine elektrochemische Pixelvorrichtung mit einem elektrochemischen Transistor und einem Elektrochrom-Element.

[44] offenbart eine molekulare Architektur für einen molekularen elektrooptischen Transistor.

[45] offenbart ein Verfahren zum Synthetisieren von Materialien mit steuerbaren elektronischen, magnetischen und/oder optischen Eigenschaften.

[46] offenbart eine hochdichte nichtflüchtige Speichervorrichtung mit einer Sandwich-Struktur.

Der Erfindung liegt das Problem zugrunde, alternative elektrische Schaltungselemente sowie Verfahren zu deren Herstellung bereitzustellen.

Das Problem wird durch das Schaltungselement sowie das Verfahren mit den Merkmalen gemäß den unabhängigen Patentansprüchen gelöst.

Ein solches Schaltungselement ist ein Schaltungselement mit einer ersten Schicht aus einem elektrisch isolierenden Substratmaterial,
- mit einem ersten elektrisch leitfähigen Material, das als mindestens ein diskreter Bereich dergestalt ausgebildet ist, dass es in das Substratmaterial eingebettet und/oder auf dem Substratmaterial aufgebracht ist,
- einer zweiten Schicht mit einem zweiten elektrisch leitfähigen Material, und
- einer monomolekularen Schicht aus Molekülen, die zum Transport von Ladungsträgern befähigt sind, wobei
   a) die monomolekulare Schicht aus den zum Transport von Ladungsträger befähigten Molekülen (die nachfolgend auch als elektrisch aktive Moleküle bezeichnet werden) zwischen der ersten Schicht aus dem elektrisch isolierenden Substratmaterial und der zweiten Schicht mit dem zweiten elektrisch leitfähigen Material angeordnet ist,
   b) die monomolekulare Schicht auf dem ersten elektrisch leitfähigen als mindestens ein diskreter Bereich ausgebildeten Material immobilisiert ist, und wobei
   c) die monomolekulare Schicht mit dem zweiten elektrischen Material der zweiten Schicht in elektrischen Kontakt steht,
- wobei jedes zum Transport von Ladungsträgern befähigte Molekül der monomolekularen Schicht aufweist
   a) mindestens eine redox-aktive Einheit, und
   b) mindestens eine erste als Elektronendonator dienende Einheit und
   c) mindestens eine zweite als Elektronenakzeptor dienende Einheit, und wobei
   d) in jedem Molekül die redox-aktive Einheit jeweils zwischen der als Elektronendonator und der als Elektronenakzeptor dienenden Einheit angeordnet ist.

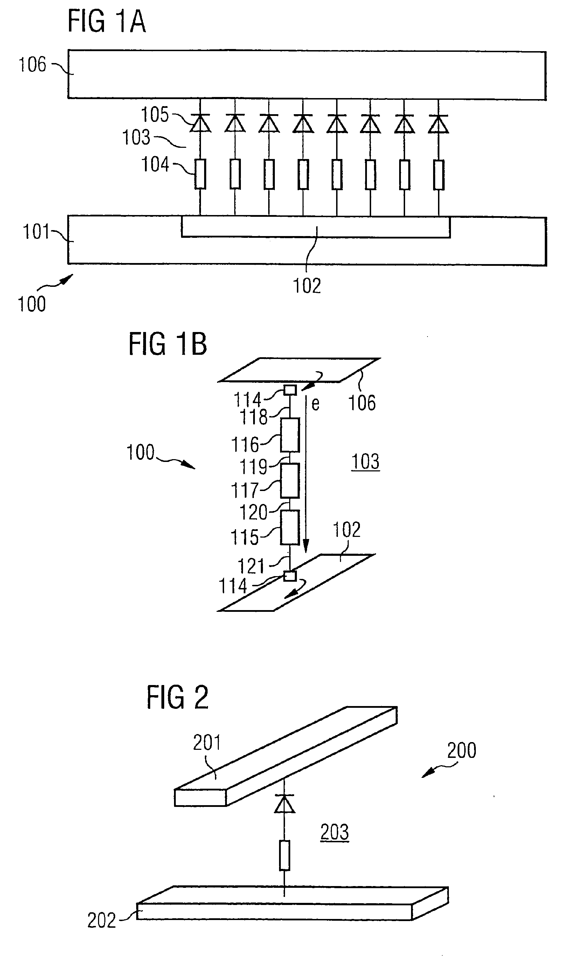

Anschaulich ausgedrückt beruht die Erfindung auf dem Prinzip, in einem Molekül, das zu einem Ladungsträgertransport (d.h. Elektronen- oder Lochtransport) befähigt ist, d.h. auf molekularer Ebene, einen veränderbaren Widerstand und eine Diode so auszubilden, dass bildlich gesprochen, die Diode und der Widerstand in Serie angeordnet sind (vgl. hierzu z.B. **Fig.1,2**). Dabei wird vorliegend der veränderbare Widerstand durch die redox-aktive Einheit der einzelnen Moleküle gebildet. Die Diodenfunktion wird durch die asymmetrische Anordnung eines Elektronendonators, d.h. einer Gruppe oder Einheit des Moleküls mit elektronenspendenden Eigenschaften, und eines Elektronenakzeptors, d.h. einer Gruppe oder einer Einheit des Moleküls, in dem Molekül bewirkt. Eine derartige Anordnung der Donator bzw. Akzeptorgruppe im Molekül bewirkt, dass eine Komponente des Dipolvektors existiert, die senkrecht auf beiden Elektrodenfläche steht. Dies führt zur Ausbildung der Diodenfunktion.

Die Ausgestaltung der zum Ladungstransport fähigen Moleküle als in Reihe geschalteter veränderbarer Widerstand und Diode, wie sie für das vorliegende Schaltungselement möglich ist, hat erstens den Vorteil, dass bei gegebenen parasitären Störungen insbesondere Parameterschwankungen größere Arrays aus den Schaltungselementen möglich sind. Zweitens ist durch die Integration von Diode und Widerstand in einem einzigen Molekül(gerüst) eine Miniaturisierung möglich, durch die hochintegrierte elektrische Speicher realisiert werden können.

Der Ladungstransport kann in der vorliegenden Erfindung sowohl durch Elektronen (n-Leiter) als auch Löcher (p-Leiter) erfolgen, d.h. der Ladungstransport in den für diesen Zweck verwendeten Molekülen ist z.B. nicht auf Elektronen beschränkt. Zur Erläuterung sei hier der Mechanismus des Ladungstransport des Bandmodells (der die "Elektronen"- und die "Lochleitung" umfasst) in ein Molekülorbitalmodell übersetzt. Dazu wird hier angenommen, dass das HOMO das höchste Orbital im Valenzband des Moleküls und das LUMO das niedrigste Orbital im Leitungsband ist.
Wird nun ein Elektron in das LUMO injiziert, kann dieses Überschuss-Elektron entlang des LUMO's durch das (die) Molekül(e) transportiert werden. Ebenso werden die nachfolgenden Elektronen transportiert. Dieser Mechanismus entspricht einer negativen Leitung. Zum Initiieren des Leitungsmechanismus wird das Molekül reduziert.

Analog lässt sich ein Oxidationsmechanismus formulieren. Dieser ist in der organischen Elektrochemie weit verbreitet. Dazu wird ein Elektron aus dem HOMO extrahiert und ein "Loch" erzeugt. Dieses "Loch", das einem Defektelektron entspricht, kann dann wiederum wandern. Real werden die Löcher immer durch Elektronen gefüllt, formal wandert - in Übereinstimmung mit dem Bändermodell - "ein Loch" d.h. eine positive Ladung.

Unter einer als Elektronendonator dienenden Einheit, die nachfolgend auch als Donator oder Donatorgruppe bezeichnet wird, wird vorliegend eine elektronenreiche Molekülgruppe oder ein einzelnes Atom verstanden, die oder das z.B. als Substituent des Grundgerüsts der hier eingesetzten aktiven Moleküle vorliegt, wobei diese Gruppe oder dieses Atom einen elektronenspendenden Effekt ausüben. Dieser Effekt kann entweder ein induktiver, d.h. der sogenannte +I-Effekt und/oder ein mesomerer Effekt, d.h. der sogenannte +M-Effekt sein. Beispiele für Molekülgruppen mit einem +I-Effekt sind z.B. Alkylgruppen wie Methyl, Ethyl, Tertiärbutyl, Arylgruppen wie Benzyl, Naphthyl oder Arylalkylgruppen wie Phenyl, die sowohl substituiert als auch unsubstituiert sein können. Im Falle von substituierten Donatorgruppen hat diese insgesamt einen elektronenschiebenden Effekt, und vorzugsweise haben alle Substituenten einen elektronenspendenden Effekt (z.B. Arylgruppen). Allerdings ist es auch möglich, dass einzelne Substituenten alleine einen elektronenziehenden Effekt (wie nachfolgend erläutert) besitzen, solange wie ein elektronenspendender Gesamteffekt resultiert. Einen +M-Effekt weisen Atome oder Molekülgruppen auf, die freie Elektronenpaare zur Verfügung stellen und die Ausbildung mesomerer Grenzstrukturen ermöglichen. Beispiele für solche Substituenten sind -OH, -OR, -NH₂, -NHR, -SR oder die höheren Homologe dieser Gruppierungen, d.h. die entsprechenden Gruppen von Arsen (As), Antimon (Sb), Selen und Tellur sowie auch die Halogene Fluor, Chlor, Brom und Iod. Dabei ist Fluor als elektronenspendender Substituent insbesondere von organischen redox-aktiven Einheiten/Molekülgruppen bevorzugt, da aufgrund seines Atomradius bei Bindungen mit Kohlenstoffatomen der +M-Effekt den durch die Elektronegativitätsdifferenz vorhandenen -I-Effekt gegenüber Kohlenstoff(-Bindungen) überwiegt.

Weitere Donatorengruppen im Sinne der Erfindung sind z.B. Donatoren, die redoxaktive oder redox-inaktive Metallzentren tragen wie Phthalocyaninyl-Gruppen (Cu, Zn, Al-Cl, etc.) oder Ferrocenyl-Gruppen (substituiert und unsubstituiert).
Die Substitution mit Metallkomplexfragmenten in α-Position führt zu einer beträchtlichen Steigerung der Donatorwirkung. Beispielsweise steigt dadurch der pkₛ-Wert einer Essigsäure von etwa 5 auf 7 - 8 an. ([7], [9] und dort zitierte Referenzen).

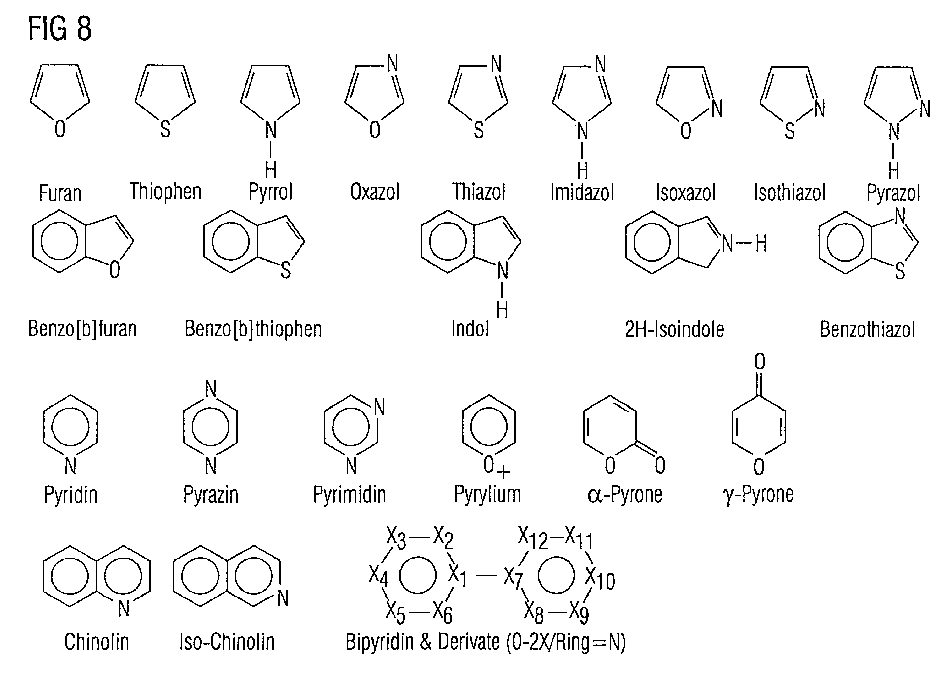

Weitere Beispiele für derartige Donatorgruppen sind elektronenreiche heteroaromatische Verbindungen wie Furan, Thiophen, Pyrrol, Oxazol, Isothiazol, etc. und deren Derivate bzw. Polyene mit entsprechenden geeigneten Substituenten (vgl. auch **Fig.8**).

Unter einer als Elektronenakzeptor dienenden Einheit, nachfolgend auch als Akzeptor oder Akzeptorgruppe bezeichnet, wird in der vorliegenden Erfindung eine Molekülgruppe oder ein Atom verstanden, die oder das einen elektronenziehenden Effekt aufweisen/aufweist, wenn die Einheit oder das Atom z.B. als Substituent am Molekülgrundgerüst angebracht ist. Folglich ist eine solche Einheit eine Gruppe mit einem -I und/oder -M-Effekt (z.B. -CN, -NO₂, -CHO, -CO-, -COOH, -COO⁻, - COSH, -COS⁻, -SO₃H) bzw. Atome wie die Halogene. Bei Verwendung als Akzeptorgruppe sind z.B. Chlor oder Brom als Halogene bevorzugt, weil bei ihnen der elektronenziehende -I-Effekt den +M-Effekt in der Regel überwiegt.

Weitere Akzeptoreinheiten, die in der vorliegenden Erfindung Anwendung finden können, sind elektronenarme (hetero)-aromatische Gruppen wie z.B. Pyrilium, Pryone, Pyrimidinium in substituierter und unsubstituierter Form. Ferner sind auch Akzeptorgruppen, die redox-aktive und redox-inaktive Metallzentren wie Cobaltocenylium-, Ferrocinium, hochfluorierte Phthalocyaninyl-Gruppen (mit Cu, Zn, oder Al als Zentralmetallatom, wobei letzteres Chlorid als weiteren Liganden besitzt) oder borhaltige Verbindungen wie Difluorborate in der Erfindung einsetzbar. Solche Fluorborate haben beispielsweise folgendes Grundgerüst
und sind durch Umsetzung der entsprechenden Acetylacetonaten mit BF₃-Etheraten erhältlich.

An dieser Stelle sei angemerkt, dass im Sinne der Erfindung die Begriffe Donator- und Akzeptoreinheit immer relativ, d.h. vergleichend zueinander, zu betrachten sind. Wesentlich für die Ausbildung der Diodenfunktion im Sinne der Erfindung ist, dass die als Elektronenakzeptor dienende Einheit eine insgesamt größere Elektronegativität im Sinne eines größeren elektronenziehenden Effekts besitzt als die als Elektronendonator eingesetzte Einheit. Die Größe der Differenz in den elektronenspendenden/ziehenden Einheiten ist verantwortlich für die Diodencharakteristik. Daraus ergibt sich, dass es auch möglich ist, zwei Molekülgruppen, die beide z.B. einen +I-Effekt ausüben, dessen Größe jedoch unterschiedlich ist, als Donator- bzw. Akzeptorgruppe einzusetzen, wenn dadurch eine zufriedenstellende Diodeneigenschaft bewirkt wird. In einer Ausgestaltung der Erfindung ist es jedoch bevorzugt, Donor- und Akzeptorgruppen mit gegenläufigen Effekten, z.B. -I und +I einzusetzen.

Unter einer redox-aktiven Einheit wird hier eine chemische Gruppierung, Molekülgruppe oder auch ein einzelnes Atom verstanden, die bzw. das reversibel Elektronen aufnehmen und abgegeben kann, d.h. chemisch gesprochen, ihren bzw. seinen Oxidationszustand durch Reduktion und Oxidation ändern kann. Diese Einheit besitzt somit mindestens zwei Atom- oder Molekülzustände, deren Redox-Aktivität durch die Gleichung M₁ + x·e⁻ ↔ M₁^{x·e-}beschrieben werden kann.

Prinzipiell kann in dem hier offenbarten Schaltungselement jedes bekannte anorganische oder organische Redoxsystem eingesetzt werden.

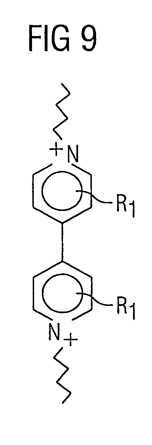

In einer Ausgestaltung des Schaltungselement weist die redoxaktive Einheit ausschließlich ein organisches Grundgerüst auf, d.h. diese redox-aktive Einheit besteht lediglich aus Kohlenstoff-, Stickstoff, Sauerstoffatomen, etc.. Ein Beispiel für eine solche Redox-Einheiten ist z.B. die in **Fig.9** und Formel (I) gezeigte Bispyridinium-Einheit. Dieses Redox-System besteht aus einem zweifach positiv geladenen Kation sowie einem einfach positiv geladenes Radikalkation. Dieser Redoxvorgang lässt sich durch die Reaktionsgleichung bipy²⁺ + e⁻ ↔ bipy^{·+} beschreiben. Bei dem Redox-Vorgang der Bispyridinium-Einheit oder -Gruppe, die auch unter der Abkürzung "bipy" bekannt, stellt das zweifach positiv geladenes Kation die elektrisch nicht leitfähige Spezies dar. Das einfach positiv geladene Radikalkation ist aufgrund des freien Elektrons elektrisch leitfähig.

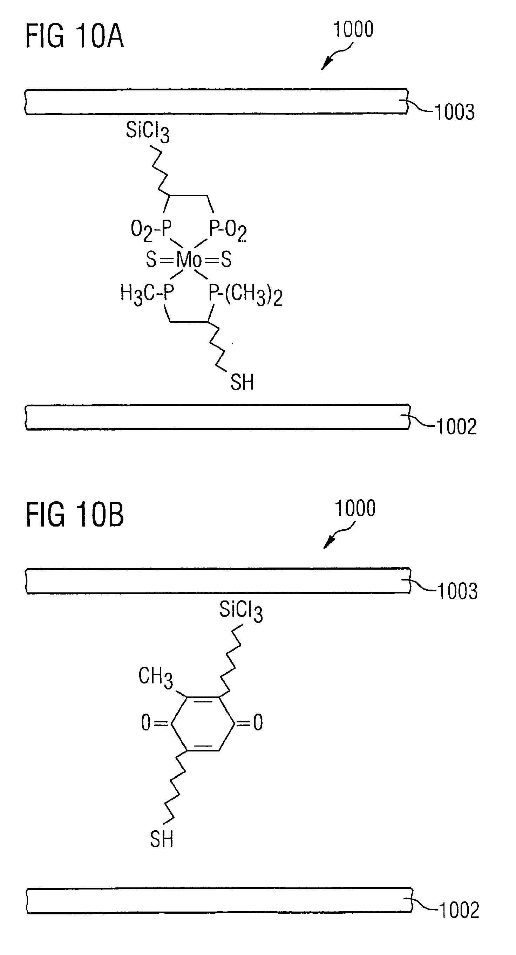

Ein anderes Beispiel für eine redoxaktive Einheit, die auf einem organischen Grundgerüst basieren, stellen chinoide Systeme dar wie ringsubstiuierte Chinone oder Thionaphtochinone dar (die zumindest eine "Ankergruppe" als Substituent zur Immobilisierung der Moleküle auf dem leitfähigen Material des ersten diskreten Bereichs tragen), (vgl. **Fig.10B**).

Bei denen auf einem organischen Grundgerüst basierenden redox-aktiven Einheiten ist vorzugsweise eine als Elektronendonator und/oder eine als Elektronenakzeptor dienende Einheit als Substituenten an unterschiedliche Atome des organischen Grundgerüsts der redox-aktiven Einheit gebunden.

In einer bevorzugten Form dieser Ausgestaltung des vorliegenden Schaltungselement ist die redoxaktive Einheit eine Bispyridinium-Einheit. Dabei weist einer der beiden Pyridinringe mindestens einen elektronenziehenden Substituenten wie z.B. -NO₂, -CN, -CHO, -COOH bzw. einen metallorganischen Akzeptor oder elektronenschiebenden Substituenten auf, während der andere (zweite) Pyridinring unsubstituiert ist oder Substituenten aufweist, die relativ zu den Substituenten des ersten Pyridinrings als Elektronenakzeptor wirken. Hierdurch (wird im Einklang mit oben beschriebenen Konzept der vorliegenden Erfindung, den Elektronendonator und den Elektronenakzeptor derart anzuordnen, das eine Komponente des Dipolvektors existiert, die senkrecht auf beiden Elektrodenfläche steht)wird stets eine Asymmetrie entlang der Bispyridiumeinheit erzeugt, die für die Diodenfunktion verantwortlich ist. Die Stärke der elektronenziehenden bzw. -schiebenden Substituenten beeinflusst zudem die Lage der Schaltpotentiale. Es sei hier angemerkt, dass durch unterschiedliche Elektrodenmaterialien (unterschiedliche Austrittsarbeiten) eine Diodencharakteristik erzeugt werden kann, auch wenn beide Pyridinringe symmetrisch substituiert sind. Die Synthese unterschiedlich substituierter Bispyridingrundkörper wird z.B. in [10] beschrieben.

In diesem Zusammenhang sei angemerkt, dass bei einer Substitution eines oder beider Pyridin-Ringe der Bispyridinium-Einheit durch eine Donator- und/oder eine Akzeptorgruppe, die redoxaktive Einheit streng genommen nicht zwischen der als Elektronendonator und der als Elektronenakzeptor dienenden Einheit angeordnet ist, sondern zwischen dem Symmetriezentrum der (unsubstituierten) "bipy"-Einheit. Der Begriff, dass "die redox-aktive Einheit zwischen dem Elektronendonator und -akzeptor angeordnet ist" schließt im Sinne der Erfindung daher generell ein, dass das Symmetriezentrum der (unsubstituierten) redox-aktiven Einheit zwischen diesen beiden Einheiten angeordnet ist. Ein weiteres Beispiel, in dem der Begriff in demselben Sinne gebraucht wird, sind substituierte chinoide Redox-Systeme. Diese sind zugleich auch ein Beispiel für Akzeptor-/Donatorsubstituierte Redox-Systeme.

In einer anderen bevorzugten Ausgestaltung weist die redoxaktive Einheit der elektrisch aktiven Moleküle ein Metallzentrum auf. Dabei kann das Metallzentrum sowohl ein einzelnes Metallatom oder ein mehrkerniges Metallzentrum ist.

Wie bereits diskutiert, findet der Ladungstransport entweder über das HOMO oder das LUMO statt. Je nachdem, ob diesen Grenzorbitalen eher Metallcharakter oder Ligandencharakter zuzuschreiben ist, ist eintretende Ladung eher am Metall oder am Liganden lokalisiert. Als anschauliches Beispiel hierfür seien die auch später diskutierten Phosphin-Verbindungen, vom Typ MoX₂(P-P); X = S, Se, Te, P-P = diphenylphosphinoethen (dppe), bis(diphenylphosphino)ethen(dppee) [vgl. 6] genannt. Dem HOMO dieser Moleküle entsprechen die freien Elektronenpaare an den Chalkogenatomen. Das LUMO hat Metalld-Orbital-Charakter. Somit hält sich in erster Näherung ein Loch am Liganden, ein Elektron am Metall auf.

Somit ist für die hier offenbarte Anwendung jeder Metallkomplex (für Diodenfunktionen unsymmetrische Metallkomplex) geeignet, der sich reversibel mindestens einmal reduzieren und/oder oxidieren lässt. Strukturell betrachtet werden in der vorliegenden Erfindung in einer diesbezüglichen Ausgestaltung oktaedrische oder pentagonal pyramidal koordinierte Metallkomplexe bevorzugt. Beispiele hierfür sind Phosphin- oder Amin-Komplexe von weiter unten ebenfalls aufgeführten Metallen wie Molybdän, Rhenium oder Ruthenium.

Als Metallzentren sind alle Metall geeignet, insbesondere diejenigen der Übergangsmetallreihen, Lanthanoiden und Actinoiden. Die Elemente der ersten Übergangsreihe (V, Cr, Mn, Fe, Co, Ni) zeigen eine besonders reichhaltige Redoxchemie. Unzählige Verbindungen werden beispielsweise in [11] erste Übergangsreihe Seiten 703 - 838; zweite und dritte Übergangsreihe 839 - 998; Lanthaniden 999- 1022 oder [8] Seiten 224 - 513 beschrieben. Diese Metallkomplexe mit Linkergruppen zu versehen, die vorliegend zur Immobilisierung der Moleküle mittels Ankergruppen auf dem ersten (oder auch auf dem zweiten elektrisch leitfähigen Bereich des Schaltungselements der Erfindung verwendet werden, ist Stand der Technik.

In einer Ausführungsform besonders bevorzugte Redoxpaare sind Fe²⁺/Fe³⁺, Cu⁺/Cu²⁺.

Unzählige Beispiele für Metallkomplexe mit zwei direkt aneinander gebundenen Metallatomen finden sich in [12], Re: 28 - 119; Mo: 139 - 230; W: 232 - 242; Mo/W: 242 - 243; Cr: 258 - 297; Triple Bonded W, Mo: 303 - 391; Rh: 431 - 488; Co, Ir, Ni, Pd, Pt: 502 - 526; Higher nuclearity Re, Mo, W: 533 - 607. In dieser Serie sind besonders die Metalle Mo, Rh, Ru, bevorzugt.

Bei Verwendung dieser Materialklasse, d.h. von Metallkomplexen (Cluster, Mehrkernkomplexe) kann die weiter unten beschriebene Schichtabscheidung zur Ausbildung eines erfindungsgemäßen Schaltungselements sequentiell erfolgen. Dabei muss der Metallkomplex nicht vollständig vor einer Abscheidung synthetisiert werden, sondern bildet sich während einer Prozessabfolge. Dies sei an folgendem Beispiel illustriert: Ein ω-Pyridylthiol wird über die übliche Gold-Schwefelkopplung auf einem Goldsubstrat immobilisiert. Die selbstorganisierte Monolage hat zugängliche Pyridyl-Endgruppen. An diese lassen sich Dirhodiumtetratrifluoracetat-komplexe axial ankoordinieren. Dazu wird der Komplex in Lösung mit der ω-Pyridylthiol in Verbindung gebracht. Die so aufgebaute aktive Monolage wird gespült und mit einer Topelektrode versehen (siehe auch [13]).

Das in der Erfindung eingesetzte Metallzentrum weist vorzugsweise mindestens ein Metall auf, das bevorzugt aus der Gruppe ausgewählt wird, die aus den Actinoiden, Lanthanoiden, den Elementen der 1. Nebengruppe des Periodensystems (PSE), Elementen der 4. Nebengruppe des PSE, Elementen der 6. Nebengruppe des PSE, Elementen der 7. Nebengruppe des PSE und der 8. Nebengruppe des PSE besteht.

Von den Elementen Kupfer, Silber und Gold der 1. Nebengruppe des Periodensystems sind dabei Kupferverbindungen bevorzugt, da Kupfer das (stabile) Redoxsystem Cu²⁺ + e⁻↔ Cu⁺ ausbildet. Beispiele für Redox-Einheiten, die auf diesem Redoxsystem basieren, sind Kupfer-Phthalocyanine oder Kupfer-Komplexe mit Phenanthrolin-Liganden (vgl. hierzu z.B. Verbindung [53] aus [14].

Bevorzugte Elemente der 6. Nebengruppe des PSE sind Chrom und Molybdän. Im Falle von Chrom ist das aus Cr²⁺ - e⁻↔ Cr³⁺ bestehende Redox-System bevorzugt. Als Molybdän-Verbindung können z.B. einkernige Molybdän-Komplexe mit zwei mehrfach gebundenen Chalkogen-Liganden und chelatisierenden Bisphosphin-Liganden verwendet werden, wie sie in [6] beschrieben und nach der dort veröffentlichten Synthese erhältlich ist. Ein Beispiel für derartige Chromverbindungen sind zweikernige Chrom-Komplexe mit verbrückenden α- Metallacarboxlaten als Liganden, wie sie in [7] beschrieben sind. Von den Elementen der 7. Nebengruppe ist Mangan bevorzugt. Eine beispielhafte Manganverbindungen ist der in [5] beschriebene Mangan-Acetat-Komplex (Mn₁₂O₁₂(CH₃COO)₁₆(H₂O)₄.

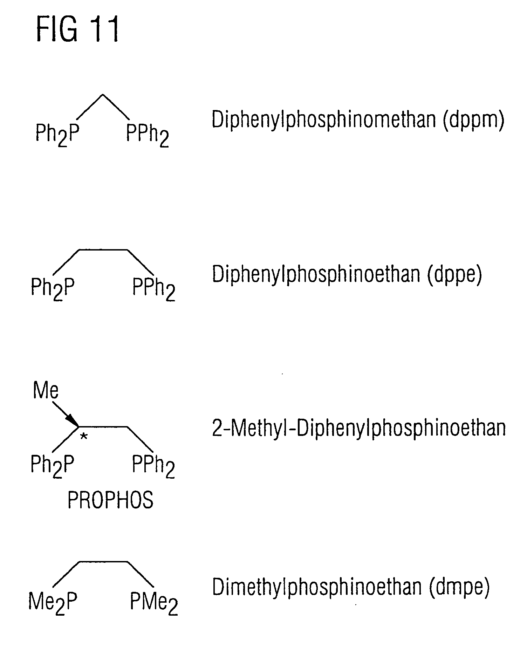

Bevorzugte Elemente der 8. Nebengruppe des PSE sind Fe, Co, Ru, Rh und Ir. Beispiele für Grundgerüste (Verbindungen), die als redox-aktive Einheiten Einsatz finden können, sind z.B. Komplexe des Eisen mit Carbonsäure-Anionen wie Acetat. Andere Beispiele sind z.B. das Ferrocen (C₅H₅)₂Fe, das zu (C₅H₅)₂Fe+ oxidiert werden kann (vgl. [8], Seite 308), sowie FerrocenDerivate, die geeignete Donator- oder Akzeptorgruppen wie NH₂ oder COOH an zumindest einem der aromatischen Ringsysteme tragen (z.B. (C₅H₅)FeC₅H₅NH₂) und z.B. in [8] auf Seiten 385, 386 beschrieben sind. Geeignete Ir, Ru- oder Co-Verbindungen sind insbesondere Phosphin- oder Aminkomplexe, lassen sich mittels Grundgerüsten bzw. Liganden aufbauen, die zum Beispiel aus zahlreichen Publikationen im Zusammenhang mit Hydrier- oder Polymerisierungs-Katalysatoren bekannt sind (siehe z.B. US Patente [15], [16], [17]). Als Beispiele für Liganden, die durch Donator- oder Akzeptorgruppen substituiert sein können, seien hier Diphenylphosphinoethan (dppe), bis(diphenylphosphino)ethen(dppee) oder 2-Methyl-Diphenylphosphinoethan (vgl. **Fig.11**) und die entsprechenden Phosphit-Derivate (bei denen der Phosphor ein oder zwei Sauerstoffatom trägt) genannt (vgl. **Fig.10, 11**). Als Beispiel für Komplexe auf Basis solcher Liganden seien Rutheniumbis(diphenylphosphino)ethenchlor-Komplexe und deren nukleophilen Additionsprodukte wie Ruthetium(aminopropylamino)bis(diphenylphosphino)ethanchlor-Komplexe [18] oder Diphenylphosphinoethyl)triethoyxsilan-Komplexe von Ruthetium oder Iridium [19] genannt. Bevorzugt ist einer Ausführungsform der Erfindung die Verwendung eines Metallkomplexes der allgemeinen Formel (III)

Mₓ(PP-LINK)_{y}L_{z},

wobei M ein Metallatom ist, das aus den Actinoiden, Lanthanoiden, den Elementen der 1. Nebengruppe des Periodensystems (PSE), Elementen der 4. Nebengruppe des PSE, Elementen der 6. Nebengruppe des PSE, Elementen der 7. Nebengruppe des PSE und der 8. Nebengruppe des PSE der Gruppe ausgewählt wird, PP ein chelatisierendes Phosphin- oder Phosphinoxid, LINK einen Linker zur Immobilisierung an der Oberfläche des elektrisch leitfähigen Materials und Leinen Liganden zur Vervollständigung der Koordinationssphäre des Komplexes darstellt, und wobei die Zahl der Koordinationsstellen x + 2y + z im Bereich von 4 - 8, bevorzugt zwischen 4 und 6 liegt. In bevorzugten Verbindungen gemäß Formel III wird das Metallzentrum aus Fe, Co, Ni, Mn, Cr, Mo, Ru, Rh oder Cu ausgewählt. Beispiele für Ligandenatome L zur Vervollständigung der Koordinationssphäre sind S, Se oder Te (vgl. oben). π-gebundene Liganden L wie Cyclopentadienylliganden besetzen in der Notation von Formel (III) nur eine Koordinationsstelle. Beispiele für Linker (Linkergruppen) sind Alkylgruppen mit 1 bis 20 Kohlenstoffatomen, wie sie in den weiter unten beschriebenen chemisch inerten Verbindungen gemäß Formel (II) definiert sind und die eine Ankergruppe aufweisen, die ebenfalls nachfolgend in Verbindung mit den elektrisch inerten Molekülen beschrieben sind (z.B. SH, SiCl₃, NH₂, COOH oder Alkoxysilane z.B. -SiRₙ(OR')₃₋ₙ mit R und R' Alkyl, R' üblicherweise Methyl oder Ethyl, n = 0-2).

Hierbei sei angemerkt, dass zur Ausbildung des Diodencharakters die vorstehend genannten Grundgerüste bzw. Verbindungen auf Basis von Metalkoordinationskomplexen durch die Verwendung unterschiedlicher Elektronendonatoren und - Akzeptoren in asymmetrischer Form verwendet werden können (vgl. **Fig.10a**).

Allgemein können, wie z.B. anhand von Formel III ersichtlich wird, darüber hinaus auch alle Metalle eingesetzt werden, die Redoxsysteme mit stabile zweiwertigen Metall-Ionen ausbilden können. Ein Beispiel dafür ist Ni, das sich z.B. in der Form von Decamethylnickelocen (C₅Me₅)₂Ni stabil zum einfach positiv oder zweifach positiv geladenen Kation (C₅Me₅)₂Ni⁺ bzw. (C₅Me₅)₂Ni²⁺ umwandeln lässt Ein anderes Beispiel sind Diacetyldixoim-Nickelkomplexe.

Für den Ladungsausgleich, der bei den Redox-Systemen durch die Änderung des Redox-Zustands erforderlich ist, sorgen geeignete Substituenten oder andere immobilisierte Moleküle bzw. geeignete Gegen-Ionen. Beispiele hierfür sind das Hydroxid-Anion (OH⁻), die Anionen der Halogenide, insbesondere Br⁻ und Cl⁻, Anionen organischer Säuren wie Acetat oder komplexe Anionen wie das PF₆⁻-Anion, oder andere komplexe Anionen wie die Anionen starker Säuren wie NO₃⁻, ClO₄⁻, oder SO₄²⁻. Weitere Beispiele für geeignete Anionen sind komplexe Anionen wie BF₄⁻, CF₃SO₃⁻ (Triflat), B(Ph)₄⁻ oder komplexe Metall-Anionen wie [PtCl₄]²⁻.

Anhand der vorstehend aufgeführten Verbindungen wird ersichtlich, dass bei bevorzugten Ausführungsformen des hier offenbarten Schaltungselements die redoxaktive Einheit eine Organometall-Verbindung oder eine anorganische Koordinations-Verbindung (eine anorganische Metall-Komplex-Verbindung wie ein Cluster oder Mehrkernkomplex) sein kann. Es wird ebenfalls ersichtlich, dass in bevorzugt verwendeten Verbindungen das Metallatom, oder die Metallatome, im Falle eines Mehrkernkomplexes, im Zentrum des Komplexes (und somit der redoxaktiven Einheit) angeordnet ist).

Ferner wird anhand der Beispiele zugleich deutlich, das die mindestens eine als Elektronendonator und als Elektronenakzeptor dienenden Gruppe (direkt an das Metallzentrum gebundene) Komplex-Liganden des Metallzentrums sein können, falls ein Metallzentrum als redox-aktives Zentrum verwendet wird. Dabei stellen Chelatliganden wie Phosphine, Phosphite, Acetylacetenato, Oximato, Acetato-, Sulfido-, Nitrilo-, oder Amino- eine bevorzugte Ausgestaltung dar.

In einer weiteren Ausführungsform ist das redoxaktive Metallzentrum an einen im wesentlichen planaren macrocylischen mehrzähnigen Liganden gebunden, der ein konjugiertes π-Elektronensystem aufweist. Dabei ist der macrocyclische mehrzähnige Ligand vorzugsweise Phthalocyanin, Naphthalocyanin oder Tetrazaphorphyrin. Als Metallzentrum wird bei dieser Ausgestaltung vorzugsweise Cu eingesetzt.

Aus den oben angegebenen Beispielen wird schließlich auch deutlich, dass die redoxaktive Einheit kovalent oder koordinativ an das Molekülgerüst der elektrisch aktiven Moleküle gebunden sein kann. Daraus folgt, dass ein zum Ladungsträgertransport hier verwendetes Molekül nicht nur kovalent miteinander verbundene Gruppierungen aufweisen muss, sondern, dass es auch möglich ist, dass einzelne Gruppen wie z.B. redox-aktive Einheiten über nicht-kovalente Wechselwirkungen in dem Molekül(gerüst) vorhanden sind.

Die zum Transport von Ladungsträger befähigten Moleküle sind auf dem mindestens einen Bereich aus dem ersten elektrisch leitenden Material über eine Ankergruppe immobilisiert. Für diese Fixierung kann im Prinzip jede funktionelle Gruppe dienen, die mit der Oberfläche des elektrisch leitenden Materials eine nicht-kovalente (z.B. eine koordinative) oder eine kovalente Bindung eingehen kann. Die Immobilisierung kann folglich durch physikalische oder chemische Wechselwirkungen erfolgen.

Diese Wechselwirkungen schließen hydrophobe oder ionische (elektrostatische) Wechselwirkungen und kovalente Bindungen ein. Beispielsweise kann bei Verwendung von Thiolgruppen als Substituent und Gold als leitfähigem Material, das auf dem Substratmaterial aufgebracht ist, die Immobilisierung durch die sogenannte Gold-Schwefel-Kopplung erfolgen.

Eine kovalente Verknüpfung kann über jede geeignete Verknüpfungschemie erfolgen. Die Wahl der jeweiligen Kopfgruppe kann auch von der Art des elektrisch leitfähigen Materials beeinflusst werden. So eignen sich zum Beispiel im Falle von Gold als leitfähigem Material insbesondere Thiole als Ankergruppen; bei Verwendung von Palladium kommen z.B. Cyanide (Nitrile) und Isocyanide (Isonitrile) als bevorzugte Kopfgruppen in Betracht.

In einer Ausführungsform des Schaltungselements ist eine kovalente oder koordinativ gerichtete Verknüpfung der redoxaktiven Verbindungen an das erste leitfähige Material bevorzugt, weil dadurch die Orientierung der Moleküle und der (elektrische) Kontakt zu den leitfähigen Materialien gewährleistet werden kann. Falls gewünscht, kann zusätzlich eine Immobilisierung über kovalente oder nicht kovalente Bindungen auch an das zweite elektrisch leitfähige Material erfolgen.

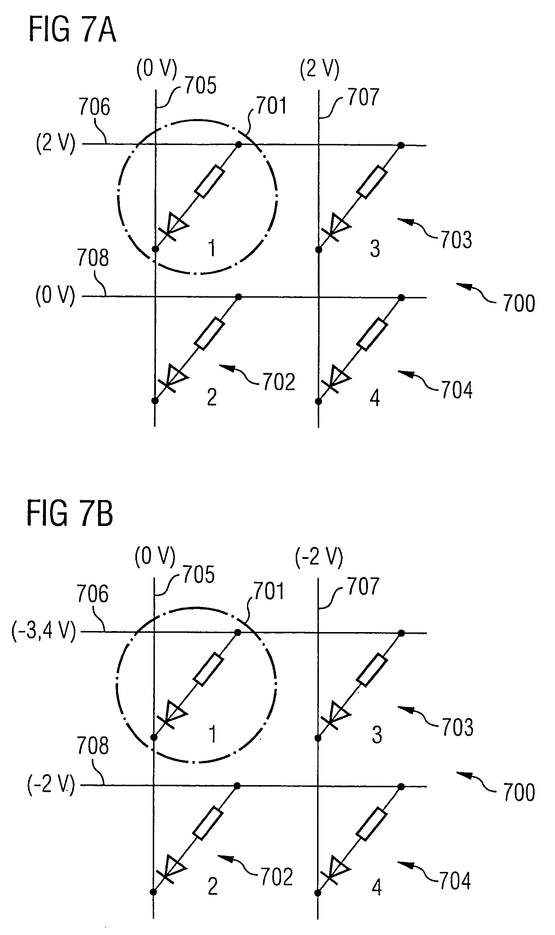

Beispiele für zur Immobilisierung geeignete Ankergruppen sind -SH, -COOH, CONH₂, COSH, -OCN, -NCO, -CN, -S-SH, -NR₂, -PR₂, -SiRₓCl₃₋ₓ (mit x= 0,1,2) wobei R für einen beliebigen geeigneten Substituenten, vorzugsweise für Wasserstoff, Alkyl, Aryl oder Arylalkyl steht. Ebenso sind komplexere mehrzähnige organische oder anorganische Liganden wie Acetylacetonato, Oximato, Acetato-, Sulfido-, Nitrilo-, oder Amino-, die eine koordinative Bindung z.B. mit Metallatomen eingehen können, als Anker- oder Kopfgruppen einsetzbar. Des weiteren sind auch (hetero)aromatische Ringsysteme, die zur koordinierenden Bindung befähigte Atomen (d.h. Atome mit freien Elektronenpaaren) im Ring aufweisen, als Ankergruppen geeignet. Solche aromatischen Ankergruppen sind z.B. Furan, Thiophen, Pyrrol, Oxazol, Thiazol, Imidazol, Isoxazol, Isothiazol, Pyrazol, Benzo[b]furan, Benzo[b]thiophen, Indol, 2H-Isoindol, Benzothiazol, Pyridin, Pyrazin, Pyrimidin, α-Pyrone, γ-Pyrone, Chinolon, Isochinolin sowie Bipyridin und Derivate davon, die in **Fig.7** abgebildet sind. Dabei können beliebige Substituenten R in den Ringsystemen vorhanden sein, die der Übersichtlichkeit wegen in **Fig.7** nicht dargestellt sind.

Die vorstehend genannten Ankergruppen fördern vorzugsweise die Ausbildung von selbstorganisierenden Schichten aus den elektrisch aktiven Molekülen und führen zu einer Ausrichtung der Moleküle gegeneinander.

In den elektrisch aktiven Molekülen können ferner Verbindungseinheiten (Spacer oder Linkergruppen) vorhanden sein, die die anderen Moleküleinheiten wie die redox-aktive Einheit und die Ankerguppen miteinander verbindet. Solche Linkergruppen sind z.B. geradkettige gesättigte (d.h. nicht konjugierte) Alkyleinheiten oder konjugierte direkte Elektronen- bzw. Lochleiter. Ein Beispiel für einen solchen Lochleiter ist eine Thiophenkette, und für einen Elektronenleiter die folgende Naphthalintetracarbonsäurediimid-Einheit:

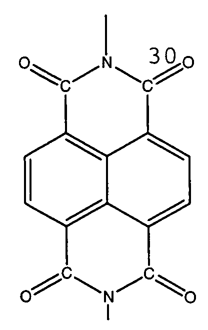

Bei solchen Naphthathalin-Verbindungen erfolgt die Verknüpfung über die Diimid-Einheit; erhältlich ist eine derartige Naphthalintetracarbonsäurediimid-Einheit durch Reaktion eines Naphthalintetracarbonsäuredianhydrid mit einem entsprechenden Amin).

Die Linkergruppen können darüber hinaus noch Substituenten oder Gruppen aufweisen, die z.B. die Diodencharakteristik der elektrisch aktiven Moleküle beeinflusst. So können z.B. Polyoxyalkylenketten als Linkergruppen dienen, bei denen die Sauerstoffatome einen elektronenspendenden Effekt bewirken. Durch Verwendung zweier unterschiedlicher Linker, z.B. einem Polyoxyalkylen-Linker auf "der einen Seite des Moleküls", vom der Redox-Einheit als (Symmetrie)-Zentrum betrachtet und einer Polyester-Linkers, dessen OCO-Gruppen einen elektronenziehenden Effekt ausüben, lassen sich die Diodeneigenschaften der elektrisch aktiven Moleküle weiter beeinflussen oder steuern.

Es ist allerdings vorliegend auch möglich, dass diese Linkergruppen nicht vorhanden sind, und einzelne Einheiten direkt miteinander verbunden sind oder in einem gemeinsamen Molekülgruppe vorkommen. In einer bevorzugten Ausgestaltung sind die Donator- und Akzeptorgruppen direkt mit der redoxaktiven Einheit verbunden. Eine andere Möglichkeit besteht darin, dass z.B. die Ankergruppen zugleich auch Bestandteil einer Donator- und/oder Akzeptorgruppe sind.

An dieser Stelle sei betont, dass in den elektrisch aktiven Molekülen nicht nur eine einzige Einheit aus Akzeptor-, Donator-Gruppe und dazwischen angeordneter redox-aktiver Einheit vorkommen kann. Vielmehr ist es auch möglich, dass zwei oder mehrere dieser Einheiten in einem elektrisch aktiven Molekül in sequentieller Abfolge vorhanden sind.

An dieser Stelle sei angemerkt, dass in der Erfindung die Diodenfunktion der elektrisch aktiven Moleküle auch noch durch die folgende Ansätze erzielt werden kann, und zwar alleine oder in Kombination mit der hier beschriebenen Ausgestaltung der elektrisch aktiven Moleküle.

Es können zum einen zwei in ihren Austrittsarbeiten sich unterscheidende Elektroden zur Kontaktierung der funktionellen molekularen Schicht verwendet werden. Dadurch wird eine Schottky-Barriere erzeugt. So kann z.B. als erstes elektrisch leitfähiges Material Gold und als zweites leitfähiges Material Titan oder Aluminium verwendet werden.

Es kann eines der leitfähigen Materialien durch Aufbringen einer Tunnelbarriere in ihrem Fermi-Level modifiziert werden. So kann ein natives Oxid z.B. durch gezieltes Aufbringen einer Zusatzschicht wie beispielsweise einer Metallschicht auf diese Weise modifiziert werden.

In einer Weiterbildung des Schaltungselements sind zusätzlich elektrisch inerte Moleküle auf dem mindestens einen diskreten Bereich aus dem ersten elektrisch leitenden Material immobilisiert. Diese elektrisch inerten Moleküle wie z.B.

Alkylthiole oder Alkylamine können zu einer "Verdünnung" der aktiven Moleküle dienen, falls dies gewünscht ist. Dabei kann sowohl eine isotrope als auch anisotrope Verteilung der elektrisch aktiven Moleküle vorliegen. Möglich ist es daher, dass ein Schaltungselement der Erfindung nur von einem einzigen elektrisch aktiven Molekül gebildet wird.

In einer anderen vorteilhaften Weiterbildung des Schaltungselements sind auf der ersten Schicht aus dem elektrisch isolierenden Substratmaterial elektrisch inerte Moleküle immobilisiert sind, die eine Matrix ausbilden, die den mindestens einen diskreten Bereich mit der monomolekularen Schicht aus redox-aktiven Molekülen umgibt.

Unter einem elektrisch inerten Molekül wird hier eine chemische Verbindung verstanden, die als elektrischer Isolator dient und vorzugsweise auch chemisch inert ist, insbesondere oxidations- oder reduktionsbeständig ist, und somit die Schaltungs- und/oder Schreib/Lese-Vorgänge, die durch die elektrisch aktiven Moleküle bewirkt werden, nicht stört. Wegen ihrer Eigenschaft als elektrischer Isolator zu dienen, bilden die Schichten aus den inerten Molekülen, die man folglich auch als Isolatormoleküle bezeichnen kann, eine isolierende Matrix, um die einzelnen aktiven Bereiche (Positionen) des Schaltungselements voneinander elektrisch zu trennen.

Prinzipiell kann jede Art von Molekülen, die die eben genannten Anforderungen erfüllen, in dem Schaltungselement der Erfindung eingesetzt werden. Dabei können auch verschiedene Arten von inerten Molekülen verwendet werden, um eine isolierende Matrix zu bilden.

In einer bevorzugten Ausführungsform des Schaltungselements sind die elektrisch inerten Moleküle Verbindungen mit einem langkettigen (gesättigten) Alkylrest.

Vorzugsweise weisen die elektrischen Moleküle eine Kopfgruppe auf, mittels derer sie an die erste Schicht aus dem elektrisch isolierenden Substratmaterial gebunden werden können. Dabei ist eine Immobilisierung über nicht-kovalente oder kovalente Bindungen möglich. Es ist möglich, die inerten Moleküle auch an der Schicht aus dem zweiten elektrisch leitfähigen Material zu immobilisieren.

Vorzugsweise sind die inerten Matrix-bildenden Moleküle Alkylsilylverbindungen der allgemeinen Formel

CH₃-(CH₂)ₚ-SiR₁R₂R₃ (II)

sind, wobei in Formel (II) p für eine ganze Zahl zwischen 1 und 30, vorzugsweise 1 und 20 steht, und wobei die inerten Moleküle über mindestens einen der Reste R₁, R₂ und R₃, der unabhängig voneinander Wasserstoff, Halogen, OR', NHR', NR'R" sein kann, wobei R' und R" Alkyl ist (typischerweise Methyl, Ethyl, Propyl, Butyl etc., n = vorzugsweise 0-5, besonders bevorzugt n= 0-2), auf der ersten Schicht immobilisiert sind. Solche Verbindungen sind kommerziell erhältlich, z.B. von ABCR/Gelest (einfachere Verbindungen auch bei Fluka oder Aldrich). Diese Verbindungen sind insbesondere bevorzugt, wenn ein Substrat auf Siliziumbasis verwendet wird. In diesem Fall erfolgt eine kovalente Bindung der inerten Isolator-Moleküle über freie Hydroxygruppen auf der Oberfläche des Substratmaterials.

An dieser Stelle sei angemerkt, dass die Länge der Alkylketten der elektrisch inerten Moleküle von der jeweils für den Ladungstransport ausgewählten Verbindung abhängt. Es ist günstig, wenn die Länge der inerten Moleküle und der "aktiven" zum Ladungstransport ausgewählten Verbindungen annähernd gleich ist, um so annähernd gleiche Dicken der monomolekularen Schichten zu erzielen. Die Anzahl der Alkyleinheiten in der isolierenden Schwanzgruppe der inerten Isolator-Moleküle kann anhand der bekannten Bindungslängen abgeschätzt werden. Allerdings ist auch eine rein empirische Vorgehensweise zur Ermittlung der am besten geeigneten Moleküllänge möglich.

Folglich ist die Verwendung von elektrisch inerten Moleküle mit einem langkettigen Alkylrest, insbesondere von Alklysilylverbindungen der Formel (II) in Schaltungselementen ein weiterer Gegenstand der Erfindung.

In einer Ausgestaltung ist das hier offenbarte Schaltungselement ein Element, bei dem eine Vielzahl diskreter Bereiche aus dem ersten elektrisch leitenden Material in das Substratmaterial eingebettet und/oder auf dem Substratmaterial aufgebracht ist. Diese Ausgestaltung ermöglicht es zum Beispiel, das Schaltungselement der Erfindung als einen elektrischen Speicher mit einer Vielzahl von Speicherzellen auszubilden.

Bei einer bevorzugten Ausgestaltung des Schaltungselements ist das erste elektrisch leitfähige Material Gold, Silber Palladium, Platin oder Silizium. Der diskrete Bereich, den das erste leitfähige Material einnimmt, kann als Elektrode in dem Substratmaterial ausgestaltet sein.

Bei einer anderen Ausgestaltung des hier offenbarten Schaltungselements weist die Schicht aus dem zweiten elektrisch leitfähigen Material Titan, Aluminium, und/oder die Materialien der ersten elektrisch leitfähigen Schicht auf. Die zweite Schicht kann ebenfalls als Elektrode ausgestaltet sein.

In einer bevorzugten Ausführungsform ist das hier beschriebene Schaltungselement zwischen zwei Elektroden angeordnet. Diese Elektroden können das erste und das zweite elektrisch leitende Material sein. In dieser Ausgestaltung, d.h. bei Anordnung zwischen zwei Elektroden, stellt das Schaltungselement der vorliegenden Erfindung aufgrund der redox-aktiven Einheit einen veränderbaren Widerstand und folglich ein Speicherelement dar.

In einer Weiterbildung, bei der eine Vielzahl von einzelnen Schichten mit den elektrisch aktiven Molekülen verwendet wird, bildet eine Anordnung derartiger Speicherelemente eine Speichermatrix, d.h. sie kann als ein elektrischer Speicher verwendet werden. Ein Vorteil dieser Ausgestaltung ist die Verwendung eines molekularen Zweipols als Speicherelement, wodurch gegenüber konventionellen Speicherelementen wie RAMs der Verdrahtungsaufwand reduziert und die Packungsdichte erhöht wird. Somit bietet das Speicherelement der Erfindung den Zugang zu einem hochintegrierbaren elektrischen Speicher. Das Speicherelement ist vorzugsweise ein Permanentspeicherelement und der auf einer Vielzahl von Speicherelementen basierende elektrische Speicher ist vorzugsweise ein Permanentspeicher. Ein solcher Permanentspeicher kann z.B. als Speicher für graphische Information dienen, beispielsweise als Speicher für "on-chip" Videofilme.

In einer bevorzugten Ausführungsform sind die zum Transport von Elektronen befähigten Moleküle Bispyridinium-Moleküle Verbindungen der allgemeinen Formel (I) 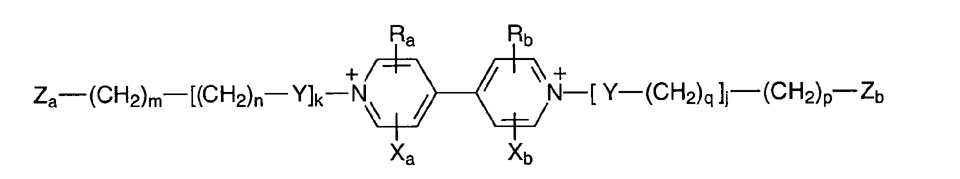 wobei in Formel (I)
eines oder mehrere der Kohlenstoffatome der beiden aromatischen Ringssysteme der Bispyridinium-Einheit unabhängig voneinander durch (mindestens) eine Gruppierung Xₐ bzw. X_{b} ersetzt sein kann, die jeweils für ein Heteroatom steht, das aus S, N und O ausgewählt wird, oder für eine Leerstelle steht (d.h. wodurch ein 5-Ring erzeugt wird)
eines oder mehrere der Kohlenstoffatome der beiden Ringssysteme jeweils unabhängig voneinander einen Substituenten Rₐ bzw. R_{b} aufweisen kann, der jeweils unabhängig für Alkyl, Aryl, Alkylaryl, Alkenyl, Alkinyl, Halogen, CN, OCN, NCO, COOH, COOR', CONHR', NO₂, OH, OR', NH₂, NHR', NR'R", SH und SR' steht, wobei R' und R" unabhängig voneinander Alkyl, Aryl, Alkylaryl, Alkenyl oder Alkinyl sein kann,
wobei Rₐ und R_{b} zusammen eine Verbrückung zwischen den beiden aromatischen Ringsystemen bilden können, die 1 bis 3 Atome umfasst, wobei die Atome unabhängig voneinander aus C, S, N und O ausgewählt werden und durch eine Einfach-, Doppeloder Dreifachbindung miteinander verknüpft sein können und ferner einen oder mehrere voneinander unterschiedliche Substituenten R_{c} aufweisen können, wobei der Substituent R_{c} die für Rₐ und R_{b} oben angegebene Bedeutung hat,
Y für eine Gruppe steht, die unabhängig voneinander aus CH₂,O, S, NH, NR', COO, CONH, CH=CH, C≡C oder Aryl ausgewählt werden kann,
Zₐ und Z_{b} unabhängig voneinander jeweils CH₃, -CH=CH₂, SH, -S-S-,-S(CO)-CH₃, SiCl₃, Si(OR)₃, SiR(OR')(OR"), SiR(OR')₂, Si(R'R")NH₂, COOH, SO₃, PO₃H, oder NH₂ sein kann, wobei R' und R" jeweils unabhängig voneinander Alkyl, Aryl, Arylalkyl, Alkenyl oder Alkinyl sein kann,
wobei n, q jeweils unabhängig voneinander einen Wert zwischen 0 und 12 annehmen können,
j und k jeweils unabhängig voneinander einen Wert zwischen 0 und 6 annehmen können,
p und m jeweils unabhängig voneinander einen Wert zwischen 0 und 12 annehmen können.

Rₐ und R_{b} sind in beiden Ringsystemen (zur Erzeugung der gewünschten Asymmetrie in der elektrisch aktiven Molekülen) nicht identisch, falls die Diodenfunktion der Moleküle gemäß Formel (I) nicht durch unterschiedliche Elektrodenmaterialien bzw. durch unterschiedliche Ankergruppen erzeugt werden.

Bevorzugt werden in dem Schaltungselement der Erfindung Verbindungen gemäß Formel (I) verwendet, bei denen die am Stickstoffatom des jeweiligen Ringes gebundene Kette jeweils nicht mehr als insgesamt als 20 Atome aufweist. Dabei sind wiederum Verbindungen bevorzugt, bei denen insgesamt beide Ketten zusammen eine Gesamtlänge von mehr als 30 Atomen aufweisen. Mit Hilfe der Indices ausgedrückt, bedeutet dies, dass (j·q + p) bzw. (k·n + m) vorzugsweise jeweils unabhängig voneinander einen Wert (ganze Zahl) nicht größer als 20 annehmen sind. Die Summe aus (j·q + p) + (k·n + m) ist dabei vorzugsweise somit nicht größer als 30. Der Klarheit halber sei hier betont, dass die Gruppe Z nicht bei dieser Betrachtung der Kettenlänge der beiden an den N-Atomen gebunden Substituenten berücksichtigt ist (vgl. die weiter unten folgenden detaillierte Definition von Z).

Da die hier verwendeten Bispyridinium-Verbindungen generell in kationischer Form vorliegen, werden die Bispyridinium-Verbindungen in Form ihrer geeigneten Salze eingesetzt. Als Gegen-Ion eignen sich z.B. das Hydroxid-Anion (OH⁻), die Anionen der Halogenide, insbesondere Br⁻ und Cl⁻, Anionen organischer Säuren wie Acetat oder komplexe Anionen wie das PF₆⁻-Anion, oder andere komplexe Anionen wie die Anionen starker Säuren wie NO₃⁻, ClO₄⁻, oder SO₄²⁻. Weitere Beispiele für geeignete Anionen sind komplexe Anionen wie BF₄⁻, CF₃SO₃⁻ (Triflat), B(Ph)₄⁻ oder komplexe Metall-Anionen wie [PtCl₄]²⁻.

Alkylgruppen können den hier beschriebenen Verbindungen von Formel (I) oder (II) geradkettig oder verzweigt, substituiert oder unsubstituiert sein. Dies trifft auch zu, wenn sie in anderen Gruppen vorkommen, z.B. in Alkoxy, Alkylmercapto, Alkoxycarbonylgruppen. Bevorzugt sind Alkylgruppen mit 1 bis 12 Kohlenstoffatomen und besonders bevorzugt sind Alkylgruppen mit 1 bis 8 Kohlenstoffatomen, insbesondere in den Verbindungen gemäß Formel (I). Der Begriff Alkyl umfasst ferner Cycloalkylgruppen mit 3 bis 8 Ringkohlenstoffatomen, die ebenfalls substituiert oder unsubstituiert sein können.

Alkenyl und Alkinylgruppen in den Verbindungen von Formel (I) oder (II) können ebenfalls geradkettig oder verzweigt, substituiert oder unsubstituiert sein. Dies trifft auch zu, wenn sie in anderen Gruppen vorkommen, z.B. in Alkoxy, Alkylmercapto, Alkoxycarbonylgruppen. Bevorzugt sind Alkenyloder Alkinylgruppen mit 2 bis 12 Kohlenstoffatomen und besonders bevorzugt sind Alkenyl- oder Alkinylgruppen mit 2 bis 8 Kohlenstoffatomen, insbesondere in den Verbindungen gemäß Formel (I). Der Begriff Alkenyl umfasst ferner Cycloalkyenylgruppen mit 3 bis 8 Ringkohlenstoffatomen, die ebenfalls substituiert oder unsubstituiert sein können.

Ein hier bevorzugter Substituent der Alkyl- Alkenyl oder Alkinylgruppen ist Halogen, d.h. Fluor, Chlor, Brom oder Iod, wobei Fluor besonders bevorzugt wird.

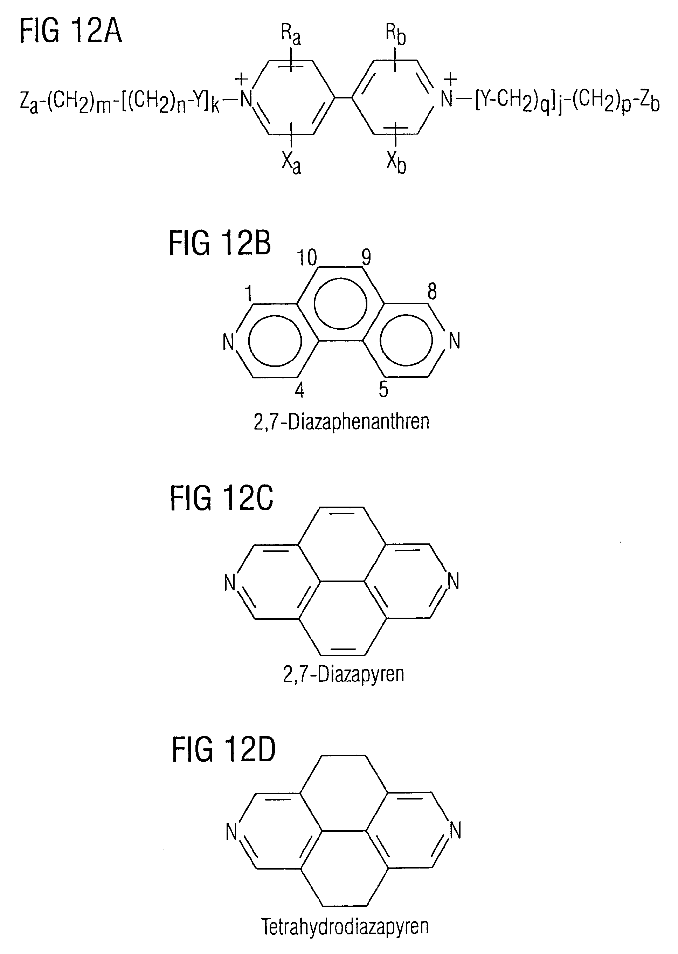

Wenn Rₐ und R_{b} zusammen eine Verbrückung zwischen den beiden Ringssystemen der Verbindungen gemäß Formel (I) bilden, sei an dieser Stelle betont, dass in diesem Fall eine HC=CH Gruppe eine bevorzugte Alkenylgruppe darstellt, die vorzugsweise eine Verbrückung zwischen den Ringatomen 2 und 9 und/oder 4 und 5 bildet. Somit gehören annelierte aromatische Systeme wie 2,7-Diazaphenanthren (im Fall von nur einer Verbrückung) oder 2,7-Diazapyrenium (im Fall von zwei Verbrückungen) zu den hier bevorzugt eingesetzten Bispyridinium -Grundgerüsten (vgl. **Fig.12**). Gleichwohl können davon abgeleitete (annelierte) heterocyclische Verbindungen in der vorliegenden Erfindung verwendet werden (vgl. Definition von Rₐ und R_{b}). Ein weiteres beispielhaftes Bispyridiumium-Grundgerüst, bei dem die Substituenten Rₐ und R_{b} eine Verbrückung bilden, ist das aus [20] bekannte Tetrahydrodiazapyren (vgl. **Fig.12**). Der Klarheit halber sei gesagt, dass derartige Systeme selbstverständlich, wie anhand der Definition von Formel 1 ersichtlich, ferner einen Substituenten R_{c} aufweisen können. In einer Ausführungsform ist R_{c} vorzugsweise Halogen, wobei wiederum Fluor bevorzugt wird.

Die Bedeutung von Aryl in den Verbindungen gemäß Formel (I) schließt substituierte und unsubstituierte carbocyclische aromatische Gruppen wie Phenyl, Naphthyl, Anthracyl sowie heterocyclische aromatische Gruppen wie N-Imidazolyl, 2-Imidazolyl, 2-Thienyl, 3-Thienyl, 2-Furanyl, 3-Furanyl, 2-Pyridyl, 3-Pyridyl, 4-Pyridyl, 2-Pyrimidyl, 4-Pyrimidyl, 2-Pyranyl, 3-Pyranyl, 4-Pyranyl, 3-Pyrazolyl, 4-Pyrazolyl, 5-Pyrazolyl, 2-Pyrazinyl, 2-Thiazolyl, 4-Thiazolyl, 5-Thiazolyl, 2-Oxazolyl, 4-Oxazolyl and 5-Oxazolyl ein. Ar beinhaltet ebenfalls annellierte polycyclische aromatische Ringsysteme wie Chinolin oder 9H-Thioxanthene-10,10-dioxid, bei denen ein carbocyclischer aromatischer Ring mit einem oder mehreren heterocyclischen Ringen kondensiert ist.

Die Darstellung von Bispyridinium-Verbindungen gemäß Formel (I) erfolgt vorzugsweise stufenweise, indem zuerst die Bispyridin-Einheit synthetisiert wird und dann die Quarternisierung am Stickstoffatom erfolgt. Dabei lassen sich unsubstituierte Bispyridine in Analogie zu den Biphenylen z.B. mittels der Ullmann-Kopplung (C-C-Verknüpfung von Arylhalogeniden mit Kupfer), oder Wurtz-sche Synthese (stufenweise Umsetzung mit Kupfer, die die Ausbildung unsymmetrischer Verbindungen erlaubt) darstellen; siehe dazu z.B. [21] Seite 597ff und die dort angegebenen Zitate. Das unsubstituierte Bispyridin ist kommerziell erhältlich.

Die Anbindung der N-Substituenten an die Bispyridium-Einheit erfolgt durch einfache Quartärnisierung mit R-X. Für den einfachsten Fall z.B. durch Umsetzung von Bipyridyl mit Reagenzien wie Methyliodid in Benzol (siehe z.B. [22] oder [23]). Dies ergibt dann direkt die symmetrisch N-substituierten Bispyridinium-Verbindungen oder wenn ein geeigneter Rest X verwendet wird, stufenweise auch unsymmetrische Verbindungen (die Wahl von X steuert hierbei die Löslichkeit in geeigneten Lösungsmitteln) und wird gefolgt von Austausch des Gegen-Ions und Substitution des zweiten N-Atoms. Allgemein kann dies wie folgt formuliert werden.

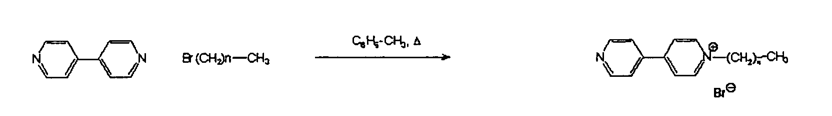

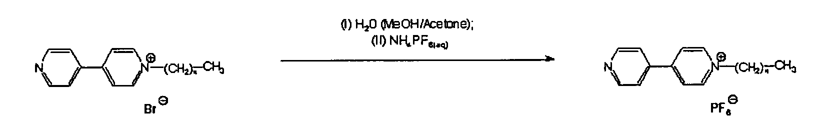

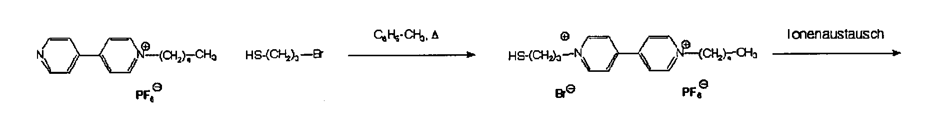

Die Substitution an den Stickstoffatomen, die zu asymetrischen Verbindungen führt, kann z.B. in einer Zweischrittreaktion erfolgen, wie in [24] anhand der Synthese von N-(n-Decyl)-N'-(10-mercaptododecyl)-4,4'-bispyridinium beschrieben (vgl. hierzu auch [25] oder [26] sowie [27]).

Die Substitution der Bispyridinium-Einheit durch Rₐ und R_{b}, wobei diese sowohl Substituenten mit elektronenspendenden als auch elektronenziehenden Eigenschaften sein können, kann als vorangehende Reaktion wie z.B. in [10], [28] oder [29] beschrieben erfolgen (vgl. insbesondere [10] Schemata 1 und 2; [28] Verbindungen 6). Ausgehend von einer Bispyridinium-Verbindung, die in 2-Position eine Hydroxylgruppe trägt (vgl. R2 in [28], ist es ferner z.B. möglich, durch Umsetzung mit P₂S₅ unter Ringbildung zu einem -S-S- bzw. -S- verbrückten System (vgl. Definition von Rₐ und R_{b}) zu gelangen. Ferner, und insbesondere bei Verwendung von 2,7-Diazaphenanthren als Bispyridinium-Einheit kann die Einführung der Substituenten Rₐ und R_{b} analog zu dem in [30] beschriebenen Verfahren durchgeführt werden (siehe dort insbesondere Verbindungen 6 und 7).

Verbindungen mit (zusätzlichen) Heteroatomen, d.h. einer oder mehreren Gruppen X, können zum Beispiel mittels der in [29] beschriebenen Synthese erhalten werden (vgl. dort Block 4 und 5).

In den Verbindungen nach Formel (I) können die Gruppe X wie auch die Substituenten R zur Beeinflussung und gezielten Steuerung der elektrochemischen Eigenschaften, d.h. insbesondere der Redoxpotentiale, der Bispyridinium-Einheit herangezogen werden. Durch solche Substitutionen kann der Ladungsausgleich bei einem Schaltvorgang in dem Schaltungselement unterstützt werden.

So lassen sich z.B. durch elektronenreiche Substituenten R, wie z.B. Alkyl oder Arylreste, die einen induktiven, elektronenspendenden Effekt (den sogenannten +I-Effekt) ausüben, die Elektronenabgabe durch die Bispyridinium-Einheit, erleichtern, und dadurch das Reduktionspotential erniedrigen. Gleiches gilt für Substituenten, die freie Elektronenpaare zur Verfügung stellen und die Ausbildung mesomerer Grenzstrukturen ermöglichen, d.h. einen +M-Effekt zeigen. Beispiele für solche Substituenten sind -OH, -OR, -NH₂, -NHR, -SR oder Fluor.

Gegenläufige Effekte, d.h. die Erhöhung des Oxidationspotentials lassen sich durch Substituenten mit elektronenziehenden -I und -M Effekten (z.B. -CN, -NO₂, - COOH, -SO₃H) bzw. mit Substituenten wie Cl, bei denen ein elektronenziehender Effekt einen elektronenspendenden Effekt überwiegt, erzielen.

Diese Effekte sollten ableitbar sein und im guten Einklang liegen z.B. mit Trends und Erkenntnissen aus der Photoelektronenspektroskopie (siehe z.B. [31]). Daraus ist zum Beispiel für substituierte Benzole das Ionisierungspotential bekannt, was mit der Energie des höchsten besetzten Molekülorbitals (HOMO) korreliert. +I und +M-Substituenten haben energiereichere HOMOs als Benzol, d.h. niedrigere Ionisierungspotentiale (entsprechend einer leichteren Oxidierbarkeit), im Falle von -M, bzw. -I-Substituenten ist der Effekt umgekehrt. Dieser Einfluss auf die Ionisierungspotentiale ist zwar nicht ganz so stark, aber auch deutlich vorhanden. Diese Beziehung sollte vor allem gelten, weil die elektrophile aromatische Substitution mit dem reaktionsbeschleunigenden Einfluss von +M/+I-Substituenten über eine Primärreaktion des aromatischen Elektronensystems mit E⁺ verläuft, d.h. also einer Oxidation des Aromaten entspricht.

Durch den Substituenten Y können ebenfalls die elektrochemischen Eigenschaften der hier verwendeten Bispyridinium-Verbindungen in der für die Substituenten R und X vorstehend beschriebenen Weise beeinflusst werden.

Eine bevorzugte Klasse von Bispyridinium-Verbindungen sind Moleküle mit langkettigen Alkylresten. Diese Verbindungen haben den Vorteil, dass sie die Ausbildung selbstorganisierender Schichten der redox-aktiven Moleküle auf der Oberfläche des elektrisch leitfähigen Materials ermöglichen. Bei solchen Verbindungen nehmen j und k in Formel (I) die Werte 0 an.

In einer Ausführungsgestaltung sind in der vorliegenden Erfindungen Moleküle bevorzugt, bei denen die am Pyridin-Stickstoffatom befindlichen (Alkyl)-Ketten eine Länge von mit 6 bis 12 Atomen aufweisen. Es ist jedoch auch möglich, kürzere oder längere Ketten zu verwenden, solange die Redoxeigenschaften der Bispyridinium-Moleküle und die Funktionalität des Schaltungselements dadurch nicht beeinträchtigt wird.

Der Buchstabe Z in Formel (I) steht für eine Kopf- oder Ankergruppe, mittels deren die Bispyridinium-Verbindungen auf den elektrisch leitfähigen Materialien aufgebracht werden. Diese Immobilisierung kann durch physikalische oder chemische Wechselwirkungen erfolgen.

Diese Wechselwirkungen schließen hydrophobe oder ionische (elektrostatische) Wechselwirkungen und kovalente Bindungen ein. Beispielsweise kann bei Verwendung von Thiolgruppen als Substituent und Gold als leitfähigem Material, das auf dem Substratmaterial aufgebracht ist, die Immobilisierung durch die sogenannte Gold-Schwefel-Kopplung erfolgen.

Bei Verwendung von Gruppen wie z.B. SH, SiCl₃ oder NH₂, COOH kann eine direkte kovalente Verknüpfung der Bispyridinium-Verbindung mit dem elektrisch leitfähigen Material erfolgen. Hierbei ist es auch möglich, Disulfid-Verbindungen (RSSR', wobei R=R'= Bipyridylhaltiges Molekül, bzw. R= Bipyridylhaltiges Molekül, und R' einfach Methyl oder kurzes Alkyl) zu verwenden, die ebenfalls Monoschichten auf Gold bilden, dies jedoch über nicht kovalente Wechselwirkungen bewerkstelligen. Möglich ist es auch, z.B. wenn freie Hydroxyl-Gruppen, auf der Oberfläche des elektrisch leitfähigen Materials ausgebildet werden können (z.B. bei Verwendung von dotiertem Silizium), Alkoxysilane für die Anbindung zu nehmen, z.B. -SiRₙ(OR')₃₋ₙ mit R und R' Alkyl, R' typischerweise Methyl oder Ethyl, n = 0-2).

Die kovalente Verknüpfung kann dabei über jede geeignete Verknüpfungschemie erfolgen. Möglich ist jedoch auch, einen kurzen separaten Linker zur Immobilisierung der redox-aktiven Verbindungen zu verwenden.

An dieser Stelle sei festgehalten, dass unabhängig von der Art des "aktiven" Moleküls (anorganischer Metall-Komplex wie Phospinverbindungen oder Bispyridinium-Verbindungen) die Wahl der jeweiligen Kopfgruppe auch von der Art des elektrisch leitfähigen Materials beeinflusst werden kann. So eignen sich zum Beispiel im Falle von Gold als leitfähigem Material insbesondere Thiole als Ankergruppen; bei Verwendung von Palladium kommen z.B. Cyanide (Nitrile) und Isocyanide (Isonitrile) als bevorzugte Kopfgruppen in Betracht und für Silizium-Oberflächen sind Silylchloride, Silylamine Si(R'R")NH₂ sowie wie oben Alkoxysilane, -SiR'ₙ(OR")₃₋ₙ mit R' und R" = Alkyl, (typischerweise Methyl, Ethyl, Propyl, Butyl etc., n = vorzugsweise 0-5, besonders bevorzugt n= 0-2) gut geeignete Ankergruppen für die Immobilisierung.

Eine andere für die Immobilisierung generell gut geeignete und daher ebenfalls bevorzugte Kopfgruppe ist -S(CO)-CH₃.

Die vorliegende Erfindung betrifft somit auch Bispyridinium-Verbindungen der allgemeinen Formel (I) in der oben angegebenen Definition.

Ferner betrifft die Erfindung die Verwendung von Bispyridinium-Verbindungen der allgemeinen Formel (I) als funktioneller Bestandteil von (elektrischen) Speichereinheiten, insbesondere als funktioneller Bestandteil von Permanentspeichern.

Generell lässt sich in einem hier beschriebenen Schaltungselement als funktionelle Einheit jede Verbindung mit einer oder mehreren Bispyridinium-Einheiten einsetzen, die die beiden hier beschriebenen Oxidationszustände reversibel durchlaufen kann.

Bei dem Verfahren der Erfindung zur Herstellung eines Schaltungselements wird eine Schicht aus einem isolierenden Substratmaterial vorgelegt. Dann wird ein erstes elektrisch leitfähigen Material an mindestens einer diskreten Position in das Substratmaterial eingebettet und/oder auf dem Substratmaterial aufgebracht.

Danach werden zum Transport von Ladungsträger befähigte elektrisch leitfähige Moleküle als monomolekulare Schicht auf dem mindestens einen diskreten Bereich aus dem ersten elektrisch leitfähigen Material immobilisiert, wobei jedes zum Transport von Elektronen befähigte Molekül der monomolekularen Schicht aufweist: a) eine redox-aktive Einheit, b) mindestens eine erste als Elektronendonator dienende Einheit, und c) mindestens eine zweite als Elektronenakzeptor dienende Einheit, und wobei in jedem Molekül die redox-aktive Einheit zwischen der als Elektronendonator und der als Elektronenakzeptor dienenden Einheit angeordnet ist.

Anschließend wird eine zweite Schicht mit einem zweiten elektrisch leitfähigen Material auf die Schicht mit den redox-aktiven Molekülen aufgebracht, wodurch die zum Ladungsträgertransport befähigten Moleküle der monomolekularen Schicht mit dem zweiten elektrischen Material der zweiten Schicht in Kontakt treten.

In einer Weiterbildung des Verfahrens werden nach der Immobilisierung der zum Ladungsträgertransport befähigten Moleküle elektrisch inerte Moleküle auf der ersten Schicht aus dem elektrisch isolierenden Substratmaterial immobilisiert. Dadurch bilden die elektrisch inerten Moleküle eine Matrix aus, die den mindestens einen Bereich mit der monomolekularen Schicht mit den redox-aktiven Molekülen umgibt.

In einer bevorzugten Ausführungsform werden die elektrisch aktiven Moleküle auch auf dem zweiten elektrisch leitfähigen Material immobilisiert, um den elektrischen Kontakt mit diesem Material zu gewährleisten. Diese Immobilisierung kann mittels einer identischen Ankergruppe in derselben Weise wie die Immobilisierung auf dem ersten leitfähigen Material erfolgen.

Als elektrisch inerte Moleküle werden vorzugsweise Verbindungen mit einem langkettigen Alkylrest, insbesondere Verbindungen gemäß Formel (II) verwendet.

Als erstes leitfähiges Material wird vorzugsweise Gold verwendet. Ferner wird das erste elektrische leitfähige Material bevorzugt in einer regelmäßigen Anordnung in das Substratmaterial eingebettet und/oder aufgebracht.

Das Aufbringen der Schicht aus dem zweiten elektrischen Material erfolgt vorzugsweise dadurch, dass das zweite elektrische Material auf die Schicht aus den elektrisch aktiven und den inerten Molekülen aufgedampft wird.

In einer weiteren Ausgestaltung des Verfahrens wird als zweites elektrisch leitendes Material Titan und/oder Aluminium verwendet.

Ausführungsbeispiele der Erfindung sind in den Figuren dargestellt und werden im weiteren näher erläutert.

Es zeigen
- Figuren 1a und 1b: eine symbolhafte Darstellung der Funktion der elektrisch aktiven Moleküle einschließlich ihrer Ausgestaltung als (monomolekulare) Schicht in einem Schaltungselements der Erfindung (**Fig.1a**) sowie einen schematischen Aufbau der elektrisch aktiven Moleküle (**Fig.1b**);
- Figur 2: eine schematische funktionelle Darstellung einer sogenannten "Crosspoint"-Zelle, bei der sich die hier eingesetzte Schicht aus den elektrisch aktiven Molekülen im Kreuzungspunkt zwischen Wort- und Bitleitung befindet;
- Figuren 3a bis 3e: ein Ausführungsbeispiel des hier beschriebenen Verfahrens zur Herstellung eines Schaltungselements;
- Figuren 4a bis 4c: eine schematische Darstellung der Kennlinie eines programmierbaren Widerstands, wie er in dem Schaltungselement der Erfindung verwirklicht, mit Lese bzw. Programmier/Löschbereich (**Fig.4a**) sowie die schematische Arbeitsweise, die anhand des Bispyridinium-Redoxsystems erläutert wird (Fig.4b, **4c**).
- Figur 5: eine schematische Darstellung einer Diodenkennlinie, wie sie durch die hier verwendeten zum Transport von Elektronen befähigten Molekülen verwirklicht ist;
- Figur 6: die schematische Darstellung des Lesevorgangs, der mit einer Ausgestaltung des Speicherelements als Speichereinheit aus mehreren Speicherelementen vorgenommen werden kann;
- Figuren 7a und 7b: die schematische Darstellung des Programmiervorgangs, der mit einer Ausgestaltung des Speicherelements als Speichereinheit aus mehreren Speicherelementen vorgenommen werden kann;
- Figur 8: als Ankergruppen in den elektrisch aktiven Molekülen verwendbare aromatische Gruppierungen;
- Figur 9: den Grundkörper einer redox-aktive Bispyridinium-Einheit, die asymmetrisch mit einer mindestens einer Donator- und Aktzeptorgruppe subsituiert ist;
- Figur 10: weitere als elektrisch aktive Moleküle in der Erfindung einsetzbare Verbindungen;
- Figur 11: beispielhafte Phosphinliganden, die in hier verwendeten elektrisch aktiven Metallkomplex-Verbindungen wie Co-, Mo- oder Ru-Komplexen eingesetzt werden können;
- Figuren 12a bis 12d: Formeldarstellungen von in der Erfindung bevorzugt verwendeten redox-aktiven Bispyridinium-Verbindungen;

**Fig.1a** zeigt eine symbolhafte Darstellung der Funktion der elektrisch aktiven Moleküle einschließlich ihrer Ausgestaltung als (monomolekulare) Schicht in einem Schaltungselements der Erfindung.

Das Schaltungselement 100 (von dem ein Ausschnitt gezeigt ist) weist das Substratmaterial 101 auf, in dem mindestens ein diskreter Bereiche 102 aus dem ersten elektrisch leitenden Material angeordnet sind. Das Substratmaterial ist ein Isolatormaterial wie Siliziumoxid oder Siliziumnitrid. Der diskrete Bereiche 102 besteht aus Gold.

Auf dem diskreten Bereich sind zum Transport von Ladungsträgern befähigten Moleküle 103 immobilisiert. Diese Moleküle bilden einen (programmierbaren) Widerstand 104 sowie eine Diode 105 aus, die in Serie angeordnet sind. Die Schicht aus den Molekülen 103 steht in Kontakt mit einer zweiten Schicht 106 aus einem zweiten elektrisch leitfähigen Material Transport von Ladungsträgern befähigten Moleküle 103. Die zweite Schicht 106 besteht ebenfalls aus Gold.

**Fig.1b** zeigt einen weiteren Ausschnitt aus dem Schaltungselement 100 und eine Ausgestaltung der elektrisch aktiven Moleküle 103. Diese Moleküle sind auf dem ersten leitfähigen Material 102 sowie der zweiten Schicht 106 jeweils über eine Ankergruppe 114 immobilisiert. Die Ankergruppe ist in beiden Fällen eine Thiolgruppe. Die Moleküle 103 weisen eine als Elektronendonator wirkende Einheit 115 sowie eine als Elektronenakzeptor dienende Einheit 116 sowie eine dazwischen angeordnete redox-aktive Einheit 117 auf. Die einzelnen Einheiten sind über "Spacerbereiche" 118, 119, 120 und 121 miteinander verbunden. Die Elektronen, die durch den Pfeil 122 symbolisiert werden, treten an der als Kathode fungierende Schicht 106 in das Molekül ein und über den als Anode fungierende diskreten Bereich 102 aus dem Molekül 103 aus.

Unter Kathode wird dabei derjenige Ort verstanden, an dem Elektronen in das Molekül eintreten bzw. entsprechend Löcher austreten. Die Anode ist folglich der Ort, an dem die entgegengesetzten Prozesse stattfinden, d.h. die Elektronen bzw. die Löcher in das Molekül eintreten.

**Fig.2** zeigt eine schematische funktionelle Darstellung einer sogenannten "Crosspoint"-Zelle 200, bei der sich die hier eingesetzte Schicht aus den elektrisch aktiven Molekülen 203 im Kreuzungspunkt zwischen Wortleitung 201 und der Bitleitung 202 befindet.

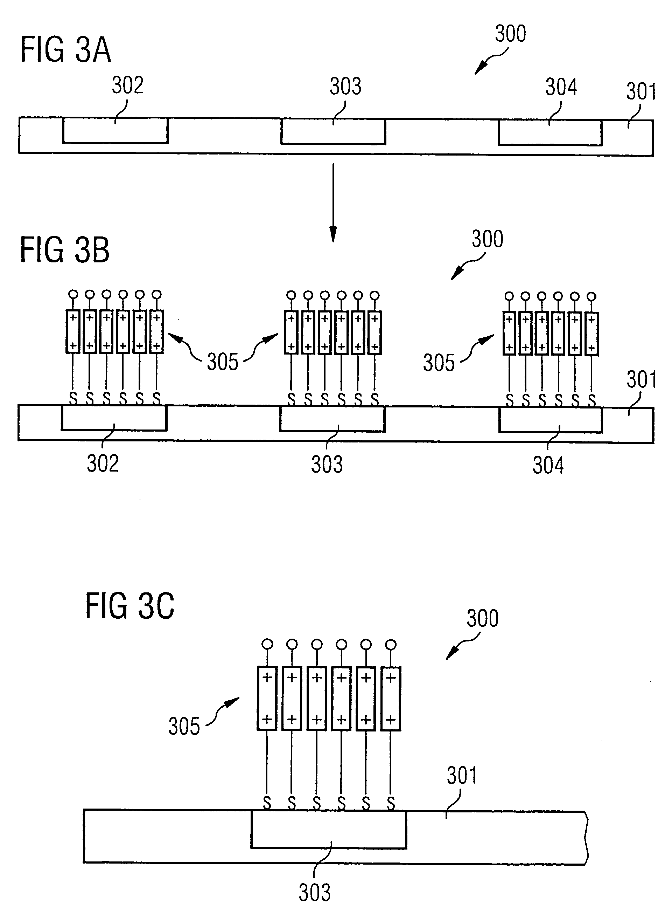

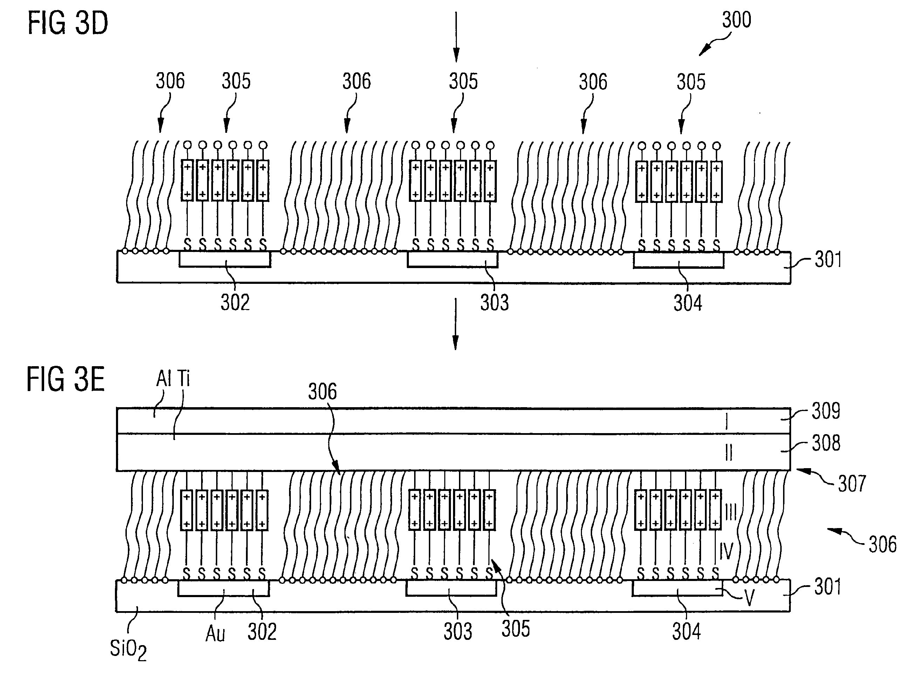

**Fig.3** veranschaulicht ein Beispiel des hier beschriebenen Verfahrens zur Herstellung eines Schaltungselements 300.

**Fig.3a** zeigt das Substratmaterial 301, in dem diskrete Bereiche 302, 303, 304 aus dem ersten elektrisch leitenden Material angeordnet sind. Das Substratmaterial ist ein Isolatormaterial wie Siliziumoxid oder Siliziumnitrid. Die diskreten Bereiche 302, 303, 304 bestehen aus Gold.

Anschließend wird auf den Bereichen 302, 303, 304 eine zum Transport von Ladungsträgern befähigte Verbindung 305 immobilisiert (**Fig.3b, 3c**), wobei jeweils auf diesen Bereichen eine monomolekulare Schicht aus den Molekülen der Verbindung 305 gebildet wird. Die Verbindung 305 ist der in **Fig.10** gezeigte einkernige Molybdän-Komplex mit zwei Chalkogen-Liganden und chelatisierenden Bisphosphin-Liganden, der wie folgt synthetisiert wird.

Zuerst werden die Molybdändistickstoffkomplexe Mo(N₂)₂(PP)₂ aus den entsprechenden Phosphinen in Anlehnung an [32] oder [33] hergestellt. Der entsprechende Distickstoffkomplex wird anschließend in Toluol mit Dibenzyltrisulfid schonend zum Molydändichalkogenkomplex umgesetzt [6]. Diese Synthesen funktionieren unabhängig von Phosphinliganden auch mit nichtchelatisierenden Abkömmlingen.

Die Einführung von Substituenten in Phosphine, die sich zur Anbindung an Oberflächen eignen, kann im Falle von Silizium als Ankergruppe erfolgen wie beispielsweise in [34] oder [35] oder [36] beschrieben. Bei Verwendung von Schwefel als Ankergruppe zur Immobilisierung kann die Synthese wie in [37] beschrieben erfolgen.

Die Immobilisierung an den Goldoberflächen der Bereiche 302, 304, 304 erfolgt über die Gold-Schwefel-Kopplung (vgl. Detailansicht in **Fig.3c**). Üblicherweise wird dafür die zu immobilisierende Verbindung in einem organischen Lösungsmittel wie Hexan oder Ethanol (je nach Löslichkeit) in einer Konzentration von 10 bis 100 mM aufgenommen und in Kontakt mit der Substratoberfläche gebracht. Die Adsorption erfolgt danach normalerweise in einem Zeitraum von 30 Minuten bis ca. 12 Stunden (über Nacht) bei Raumtemperatur. Danach wird die Oberfläche sorgfältig mit Lösungsmittel abgespült. Die so mit den monomolekularen Schichten versehenen Substrate sind in Luft und Lösungsmittel (bei nicht zu hoher Temperatur) gut haltbar. Eine Übersicht über hier verwendbare Immobilisierungsverfahren bietet [38].

Danach werden elektrisch inerte Moleküle 306 auf der Schicht des Substratmaterials 301 als monomolekulare Schicht immobilisiert (**Fig.3d**). Als Moleküle 306 dienen hierbei Trichloralkylsilane oder Alkoxysilane mit einer Alkylkettenlänge von ca. 10 bis 30, vorzugsweise mit bis zu ca. 20 Kohlenstoffatomen. Die Immobilisierung erfolgt über kovalente Bindungen des Siliziumatoms mit Hydroxylgruppen auf der Oberfläche des als Substratmaterials 301 verwendeten Siliziumdioxids.

Im nächsten Schritt erfolgt die Ausbildung der zweiten elektrisch leitfähigen Schicht 307 des Schaltungselements (**Fig.3e**). Dazu wird zunächst eine Schicht 308 aus Titan auf die monomolekularen Schichten der Verbindung 305 (hier des Molybdän-Komplexs 305) und der Isolatormoleküle 306 unter Vakuum aufgedampft. Anschließend wird eine weitere Schicht 309 aus Aluminium unter Vakuum aufgedampft. Im Prinzip sind zum Aufbringen der zweiten elektrischen Schicht alle Verfahren anwendbar, welche eine schonende Abscheidung der Metallschicht ermöglichen.

Die Diodenfunktion, die die Phosphinliganden des Moleküls 305 bewirken, wird in dieser Ausgestaltung durch die Modifikation des Fermi-Levels der zweiten elektrischen Schicht beeinflusst. Auf diese Weise wird ein Schaltungselement mit einer Mehrzahl von molekularen Widerständen ausgebildet, das sich z.B. als Speicherelement einsetzen lässt.

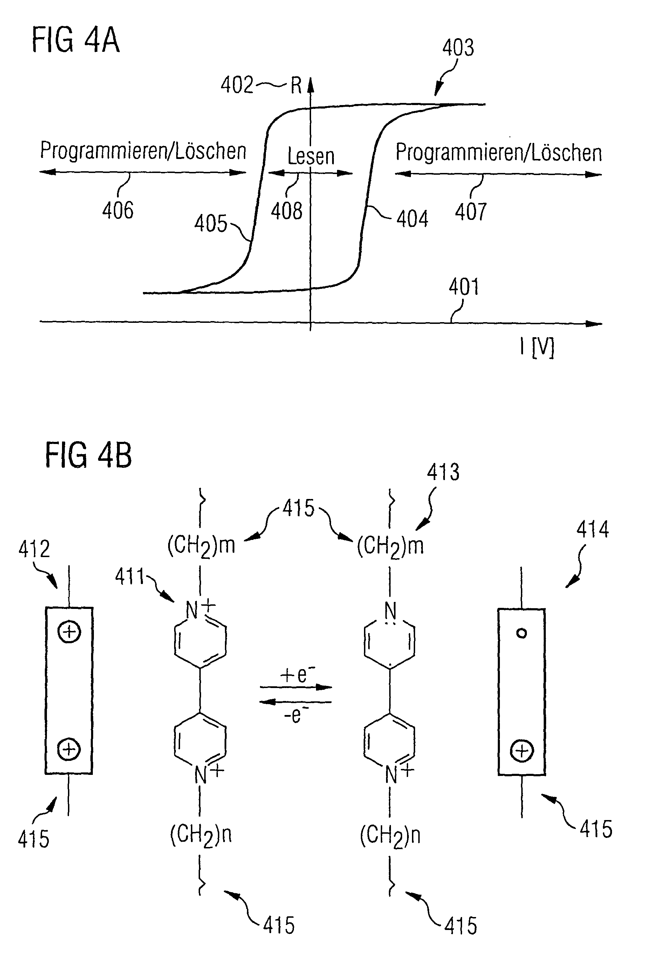

**Fig.4a** zeigt in schematischer Darstellung die Kennlinie eines programmierbaren Widerstands, wie er in dem Schaltungselement der Erfindung verwirklicht, mit seinem Lese bzw. Programmierund Löschbereich. Aufgetragen ist der Widerstand 402 dieser Kennlinie 403 als Funktion der Spannung 401. Der Widerstand 402 ist als Hysterese ausgebildet (siehe Kennlinien 404 und 405) und ändert seinen Wert, wenn eine bestimmte positive oder negative Spannung an die elektrisch aktiven Moleküle angelegt wird. Bei Werten, die größer als dieser Spannungswert sind, kann das Schaltungselement programmiert (beschrieben) oder gelöscht werden (Bereiche 406 und 407) Innerhalb des Bereichs 408 kleiner Potentialänderungen erfolgt das Auslesen des Schaltungselements.

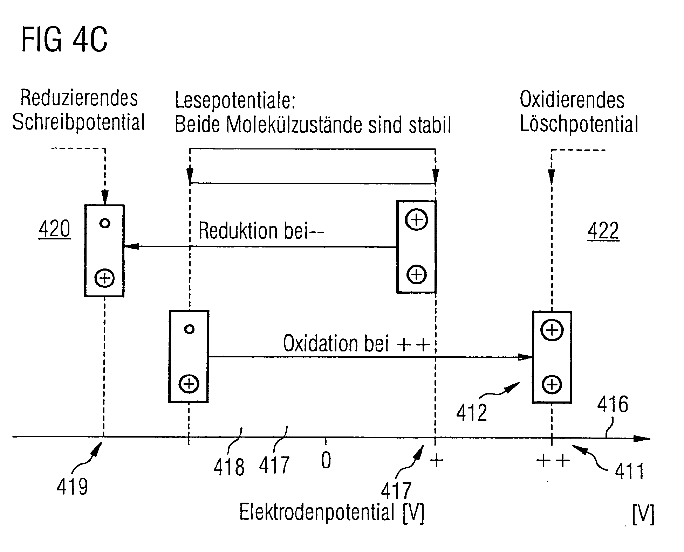

**Fig.4b,4c** veranschaulichen schematisch die Potentialverhältnisse und Arbeitsweise (das Schaltprinzip) eines als Speicherelement ausgestalteten Schaltungselements, das auf dem Bispyridinium-Redoxsystem basiert.

Das zweifach positiv geladene Kation 411, das in der Schemadarstellung die Bezugsziffer 412 trägt, ist die Spezies, die unterhalb eines vorgegebenen Reduktionspotentials nicht leitend ist.

Oberhalb dieses vorgegebenen Reduktionspotentials stellt das Kation 411 einen Elektronenakzeptor dar. Unter Aufnahme eines Elektrons wandelt sich das zweifach positiv geladene Kation zum einfach positiv geladenen Radikalkation 413 (414 in der schematischen Darstellung) um. Durch das freie Elektron wird das Radikalkation elektrisch leitfähig. Dieser Zustand liegt unterhalb des Oxidationspotentials des Radikalkations 413 vor. Oberhalb des Oxidationspotentials stellt das Radikalkation folglich einen Elektronendonator dar. Die durch das Bezugszeichen 415 gekennzeichneten Alkylketten, die über das Stickstoffatom des jeweiligen Rings am Pyridinringsystem gebunden sind, nehmen an sich nicht an dem Redoxvorgang teil, sondern wirken eher als Isolator. Allerdings können in die Alkylketten eingebaute Substituenten wie vorstehend beschrieben z.B. durch +M und/oder +I-Effekte die Lage des Redoxpotentials beeinflussen.

Beim Anlegen von kleinen positiven oder negativen Potentialen 417 (das Potential ist auf der x-Achse 416 in seiner relativen Lage angezeigt) werden noch keine Veränderungen des Redoxzustands initiiert (**Fig.4c**). Dieser Bereich 418 wird zum Lesen der Speicherzelle verwendet. Das Anlegen eines größeren negativen Potentials 419 bewirkt eine Reduktion des Moleküls (Übergang zum Radikalkation 414). Dieser Bereich 420 dient zum Beschreiben des Speicherelements. Wird ein größeres positives Potential 421 an das Speicherelement angelegt, bewirkt dies eine Oxidation des Moleküls, d.h. eine Umwandlung in das Dikation 412. Dieser mit dem Potential 421 beginnende Bereich 422 wird zum Löschen des Speicherelements verwendet. Da dieser Redox-Prozess reversibel ist, können beliebig viele Schreib-, Lese- und Lösch-Vorgänge durchgeführt werden.

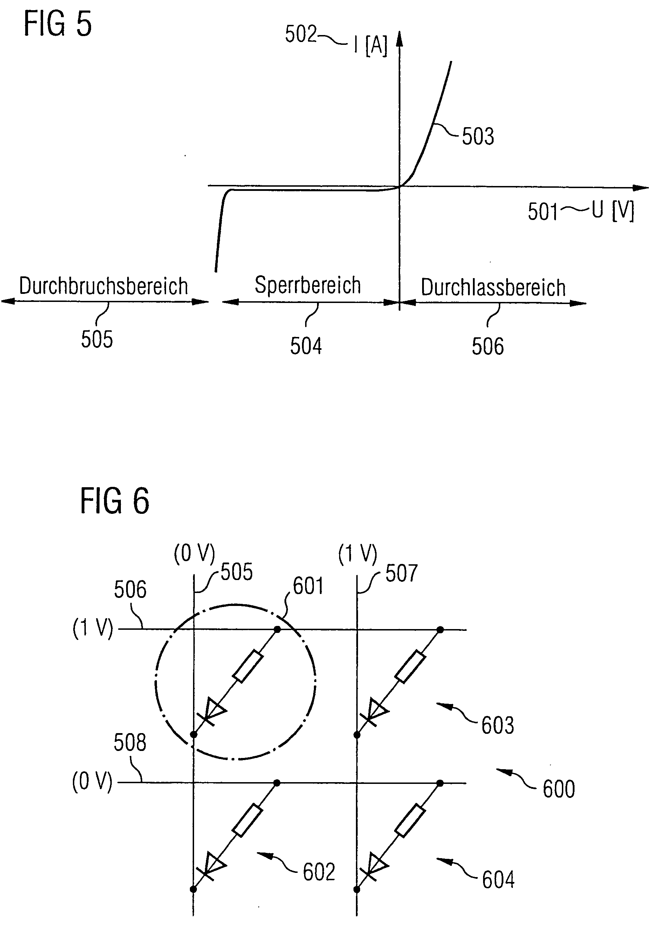

**Fig.5** zeigt eine schematische Darstellung einer Diodenkennlinie, wie sie durch die hier verwendeten zum Transport von Elektronen befähigten Molekülen verwirklicht ist. Die Kennlinie 503 ist dargestellt als Auftragung des elektrischen Stroms (I) 502 gegen die Spannung (V) 501. Die Kennlinie weist einen Sperrbereich 504 sowie einen Durchlassbereich 505 und 506 bei höheren negativen bzw. positiven Potentialen auf. Der Durchbruchsbereich zerstört dabei nicht die Diodenfunktion. Für das Lesen eines hier offenbarten Schaltungselements wird der Potentialbereich 504 der Durchlasslinie und der Sperrkennlinie verwendet. Für das Programmieren bzw. das Löschen der Diode wird dagegen auch der Durchbruchsbereichs 505 und 506 verwendet. So wird einerseits erreicht, dass die hier beschriebenen "molekularen Dioden" im Sperrbereich 504 einen großen Teil der Spannung aufnehmen können. Andererseits kann durch den Durchbruchsbereich 505, 506 die Diode und somit das Schaltungselement der Erfindung in beide Richtungen, d.h. durch Elektronenabgabe oder -aufnahme, programmiert werden.

**Fig.6** zeigt die schematische Darstellung des Lesevorgangs, der mit einer Ausgestaltung des Speicherelements als Speichereinheit aus mehreren Speicherelementen vorgenommen werden kann.

In diesem Beispiel liegen die Diodenschwellen bei -2,2 Volt (Durchbruch) bzw. 0,8 V (Durchlass). Die Diode leitet idealerweise sowohl im Durchbruch als auch im Durchlass perfekt, während sie im Sperrbereich perfekt sperrt. Zum Lesen wird eine Spannung von 0,2 V am Widerstand (d.h. den elektrisch aktiven Molekülen) verwendet, zum Programmieren reicht (Schreiben, Löschen) eine Spannung von 1,2 V aus.

Bei dem Lesevorgang gemäß **Fig.6** wird die mit einem Kreis versehene Zelle 601 des Speicherelements 600 der Erfindung gelesen. Die Zellen 602, 603 und 604 werden nicht gelesen. Für das Lesen der Zelle 601 wird an die angesprochene Bitleitung 605 eine Spannung von 0 V angelegt, während an der angesprochenen Wortleitung 606 eine Spannung von 1 V anliegt. Damit ist die in der Zelle 601 ausgebildete Diode in Flussrichtung gepolt, der Widerstand kann bestimmt werden.

Die nicht angesprochenen Wortleitungen werden mit 0 V und die nicht angesprochenen Bitleitungen werden mit 0 V beaufschlagt. Die nicht angesprochene Bitleitung an der Zelle 602 und die nicht angesprochene Zelle 603 an der Wortleitung 608 hat daher keinen Spannungsabfall, während die nicht angesprochenen Zelle 604 an den nicht angesprochenen Wortleitungen und Bitleitungen sperren. Es fließen somit keine Fehlströme.

**Fig.7a** zeigt schematisch den Programmiervorgang, der mit einer Ausgestaltung des Speicherelements als Speichereinheit aus mehreren Speicherelementen vorgenommen werden kann.

Dabei wird an die angesprochene Wortleitung 706 eine Spannung von 2 Volt und an die Bitleitung 705 eine Spannung von 0 Volt angelegt. Die Diode leitet und trägt noch einen Spannungsabfall von 0,8 Volt. So entsteht ein Spannungsabfall von 1,2 V über dem Widerstand der angesprochenen Zelle 701, der ausreicht, um die Zelle 701 mit dem entsprechenden Datum zu programmieren. An die nicht angesprochene Wortleitung 708 an die nicht angesprochene Bitleitung 707 wird eine Spannung von 2 Volt angelegt. So tragen die Zellen 702 und 703 keinen Spannungsabfall. An der Zelle 704 liegt in Sperrrichtung eine Spannung von 2 Volt an, die näherungsweise vollständig von der Diode aufgenommen werden.

**Fig.7b** zeigt den entgegengesetzten Programmiervorgang. Wenn an die angesprochene Bitleitung 705 eine Spannung von 0 Volt und an die angesprochene Wortleitung 706 -3,4 Volt zur Programmierung des inversen Datums angelegt werden, und weiterhin an die Leitungen 707 und 708 eine Spannung von -2 Volt angelegt werden, läuft die Diode der angesprochenen Zelle 701 auf die Durchbruchsspannung. Die Dioden der Zellen 702 und 703 sperren, während an der Zelle 704 keine Spannung anliegt. Auch in diesem Fall treten keine Fehlströme an den nicht angesprochenen Zellen auf. Dies macht das hier beschriebene Speicherelement unanfällig gegen Schwankungen.

**Fig.8** zeigt als Ankergruppen in den elektrisch aktiven Molekülen verwendbare aromatische Gruppierungen;

In **Fig.9** ist der Grundkörper einer redox-aktiven Bispyridinium-Einheit gezeigt, die asymmetrisch mit einer mindestens einer Donatoreinheit R₁ und einer Akzeptoreinheit R₂ subsituiert ist;

**Fig.10a.** zeigt einen einkernigen Molybdän-Komplex mit zwei mehrfach gebundenen Schwefel-Liganden und chelatisierenden Bisphosphin-Liganden. Das Molybdänatom stellt das redoxaktive Zentrum dar, einer der beiden Bisphosphin-Liganden ist mit Methylgruppen substuiiert und wirkt als Donatoreinheit im Sinne der Erfindung. Der andere Bisphosphin-Ligand trägt elelektronenziehende (Sauerstoff)-Substituenten und wirkt als Elektronenakzeptor-Einheit. Die Bisphosphin-Liganden haben ferner jeweils eine Alkylkette mit einer SH bzw. SiCl₃-Ankergruppe zur Immobilisierung an die beiden Schichten 1002 und 1003 des Schaltungselements 1000.

**Fig.10b** zeigt ein Ubichinonderivat. Bei diesem stellt die Chinongruppe die redox-aktive Einheit dar, die durch eine -CH₃ bzw. eine COOC₂H₅ Gruppe als Donator- bzw. Akzeptorgruppe in Sinne der Erfindung substituiert ist. Ferner trägt die Ubichinongruppe über Alkylketten als Spacermolekül eine -SH bzw. SiCl₃-Ankergruppe zur Immobilisierung an die beiden Schichten 1002 und 1003 des Schaltungselements. Ein weiteres Beispiel für eine redox-aktive Verbindung mit einen chinoiden System sind Thionaphtochinone gemäß Formel IV 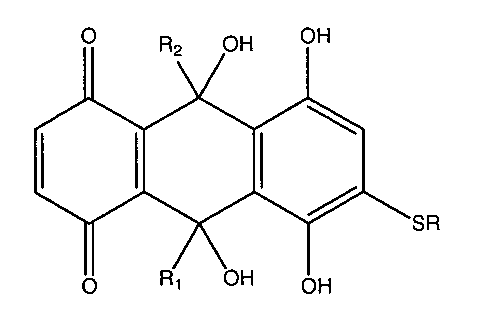 (IV), bei denen R1 und R2 unterschiedliche Substituenten, z.B. Alkylketten oder H sind. Die Immobilisierung an der Schicht 1002 erfolgt mittels des Substituenten R, der mit dem als Ringsubstituent gebundenen Schwefelatom eine Thioetherbindung eingeht und zum Beispiel eine aliphatische Alkylkette mit einer Siliziumgruppe als Ankergruppe sein kann (vgl. [39]).

In diesem Dokument sind folgende Veröffentlichungen zitiert:
[1] C.P. Collier et al., Electronically configurable molecular-based logic gates, Science, Vol. 285, S. 391-394, 1999
[2] C.P. Collier et al., A [2]Catenane-based solid state electronically reconfigurable switch, Science, Vol. 289, S. 1172-1175, 2000
[3] D.I. Gittins et al., A nanometre-scale electronic switch consisting of a metal cluster and redox-addressable groups, Nature, Vol. 408, S. 67-69, 2000
[4] M.A. Reed et al., Prospects for molecular-scale devices, IEEE, Tech. Digest, S. 227-230, 1999
[5] C. Joachim et al., Elektronics using hybrid-molecular and mono-molecular devices, Nature, 408, S. 541-548, 2000
[6] F.A. Cotton und G. Schmid, G., Monomolecular Molybdenum (IV) complexes with multiply bonded chalcogen ligands in trans configuration and chelating bisphosphine ligands, Inorg. Chem, 36, 1997, S. 2267-2278
[7] F.A. Cotton und Schmid, G., Quadruply bonded dichromium complexes with bridging metalla-carboxylates, Inorganica Chimica Acta, 254, 1997, S. 233-238
[8] C. Elschenbroich und A. Salzer, Organometallchemie, 2.Auflage 1988, B.G. Teubner Verlag, Stuttgart, Deutschland, ISBN 3-519-13501-9
[9] M. Akita, N. Kakinuma und Y. Moro-oka, J. Organomet. Chem. 1988, 348, 91
[10] R. Bauer, P. Nussbaumer, M. Neumann-Spallart, "On the Synthesis and Electrochemical Properties of Some New Bipyridinium and Related Compounds, Z. Naturforsch. 43b, Seiten 475-482, 1988
[11] F.A. Cotton, G. Wilkinson Anorganische Chemie, Verlag Chemie, ISBN-3-527-25903-1"
[12] Cotton, F. A.; Walton, R. A. *Multiple Bonds Between Metal Atoms*, 2nd ed.; Clarendon: Oxford, 1993, ISBN 0-19-855649-7
[13] F.A. Cotton, et al. "Supramolecular Assemblies of Dimetal Complexes with Polydenta N-Donor Ligands: From a Discrete Pyramid to a 3D Channel Network", Inorg. Chem. 2002, 41, Seiten 2903-2908
[14] Balzani V. et al. Künstliche molekulare Maschinen, Angew. Chem 2000, 112, Seiten 3484-3530
[15] US Patent 4,134,906
[16] US Patent 3,907,852
[17] US Patent 4,965,234
[18] Barkely, J. et al., Nucleophilic Addition to Complexes of (Ph2P)2C:CH2 as a route to functionalized redox - active Ruthenium(II)-Diphosphine Complexes, Inorganic Chemistry, 1997, 36(27), Seiten 6188-6196)
[19] Allum K., et al. Supported transition metal complexes III. Catalysts for the hydrogenation of olefins and dienes, J. Organmet. Chem. (1976), 107(3), Seiten 393-405)
[20] Kawashima et al., The synthesis and properties of a methylviologen analogue, Tetrahedron Letters, Vol. 25, Nr. 25, S. 1585-1586, 1984]
[21] J. March, Advanced Organic Chemistry, 3. Auflage (Wiley, New York, 1985), S. 597ff
[22] P. Stehle et al. Isotachophoresis of quarternary 4,4'-Bipyridylium Salts -Analytical Control of synthesis and purification procedures, J. Chromatogr. 449(1), 299-305, 1988
[23] Blacker et al., Molecular anion binding and substrate photooxidation in visible light by 2,7-diazapyrenium cations, Helvetica Chimica Acta, 70, S. 1-12, 1987
[24] H.C. DeLong & D.A. Buttry, Ionic Interactions play a major role in determining the electrochemical behaviour of self-assembling viologen monolayers, Langmuir, 6, S. 1319-1322,1990
[25] X. Tang et al., A vibrational spectroskopic study of the structure of electroactive self-assembled monolayers of viologen derivatives; Langmuir, 10, S. 2235-2240, 1994
[26] H.C. DeLong & D.A. Buttry, Environmental Effects on redox potential of viologen groups in electroactive self-assembling viologen monolayers, Langmuir, 8, S. 2491-2496, 1992
[27] D.I. Gittins et al., Diode-like electron transfer accross nanostructured films containing a redox ligand, J. Mater. Chem., Vol. 10, S. 79-83, 2000
[28] E.V. Dehmlow & A. Sleegers, Synthesen von hydroxilierten Bipyridinen, III: Synthese von unsymmetrischen und symmetrischen Dihydroxybipyridinen, Liebigs Ann. Chem. 9, S. 953-959, 1992
[29] H. Fischer & A.L. Summers, Synthesis, polarography and herbicidal activity of quaternary salts of 2-(4-pyridyl)-1,3,5-triazines, 5-(4-pyridyl)pyrimidine, 2-(4-pyridyl)pyrimidine and related compounds, J. Heterocycl. Chem. 17(2), S. 333-336, 1980
[30] E.W. Gill & A. W. Bracher, The synthesis and characterisation of some diazaphenanthrene derivatives, J. Heterocyclic Chem. 20, S. 1107-1109, 1983
[31] D. W. Turner, Molecular Photoelectron Spectroscopy, Wiley, London, 1970
[32] Dilworth. J.R., Richards, R.L.; Chen.J.-J.; McDonald, J. W. Inorg. Synth. (1980), 20, 119
[33] Anker, M.W.; Chatt. J.; Leigh, G.J., Wedd, A.G.; J. Chem. Soc., Dalton Trans. (1975) 23, 2639
[34] Lindner, E. et al. Supported Organometallic complexes Part XXIII: A general synthetic route for the synthesis of mono-T-silyl functionalized aromatic phosphins as ligands for chemistry in interphases, Journal of Organometallic Chemistry (2001), 628 (2), Seiten 151-154
[35] Erard, J.F. The preparation of mixed organic layers chemically bonded on silicon dioxide, Colloidal. Surf. (1984), 9(2), Seiten 109-132)
[36] DeCroon, M.J.M.H & Coenen, J. W. E.: Kinetics and mechanism of cyclohexene hydrogenation with anchored Wilkinsion complex: Comparision with the behaviour of the homogenous catalyst, J. Mol. Cat. (1981) 11(2-3), Seiten 301-311
[37] US Patent 3,842,108
[38] A. Ulman, Formation and Structure of Self-Assembled Monolayers, Chem. Rev., vol 96(4), 1533-1554 (1996)
[39] Switching Element and its Manufacturing Method, JKT-9-36389, Feb. 7, 1997
[40] DE 199 59 904 C2
[41] DE 101 32 640 A1
[42] WO 03/041182 A2
[43] WO 02/071139 A1
[44] WO 02/049124 A2
[45] WO 96/007487 A1
[46] US 6,212,093 B1

## Patentansprüche

1. Schaltungselement mit einer ersten Schicht aus einem elektrisch isolierenden Substratmaterial,
• mit einem ersten elektrisch leitfähigen Material, das als mindestens ein diskreter Bereich dergestalt ausgebildet ist, dass es in das Substratmaterial eingebettet und/oder auf dem Substratmaterial aufgebracht ist,
• einer zweiten Schicht mit einem zweiten elektrisch leitfähigen Material, und
• einer monomolekularen Schicht aus Molekülen, die zum Transport von Ladungsträgern befähigt sind, wobei
a) die monomolekulare Schicht aus den zum Transport von Ladungsträgern befähigten Molekülen zwischen der ersten Schicht aus dem elektrisch isolierenden Substratmaterial und der zweiten Schicht mit dem zweiten elektrisch leitfähigen Material angeordnet ist,
b) die monomolekulare Schicht auf dem ersten elektrisch leitfähigen als mindestens ein diskreter Bereich ausgebildeten Material immobilisiert ist, und wobei
c) die monomolekulare Schicht mit dem zweiten elektrischen Material der zweiten Schicht in elektrischen Kontakt steht,
• wobei jedes zum Transport von Ladungsträgern befähigte Molekül der monomolekularen Schicht aufweist
a) mindestens eine redox-aktive Einheit, mittels welcher ein veränderbarer Widerstand gebildet ist, und
b) mindestens eine erste als Elektronendonator dienende Einheit und
c) mindestens eine zweite als Elektronenakzeptor dienende Einheit, wobei mittels des Elektronendonators und mittels des Elektronenakzeptors eine Diode gebildet ist, und wobei
d) in jedem Molekül die redox-aktive Einheit jeweils zwischen der als Elektronendonator und der als Elektronenakzeptor dienenden Einheit angeordnet ist.

2. Schaltungselement nach Anspruch 1,
bei dem die redoxaktive Einheit ausschließlich ein organisches Grundgerüst aufweist.

3. Schaltungselement nach Anspruch 2,
bei dem die mindestens erste als Elektronendonator und/oder die zweite als Elektronenakzeptor dienende Einheit als Substituenten an unterschiedliche Atome des organischen Grundgerüsts der redox-aktiven Einheit gebunden sind.

4. Schaltungselement nach Anspruch 2 oder 3,
bei dem die redoxaktive Einheit eine Bispyridinium-Einheit ist.

5. Schaltungselement nach Anspruch 1,
bei dem die redox-aktive Einheit ein Metallzentrum aufweist.

6. Schaltungselement nach Anspruch 5,
bei dem die redox-aktive Einheit ein einzelnes Metallatom oder ein mehrkerniges Metallzentrumist.

7. Schaltungselement nach Anspruch 5 oder 6,
bei dem das Metallzentrum mindestens ein Metall aufweist, das aus der Gruppe ausgewählt wird, die aus den Actinoiden, Lanthanoiden, Elementen der 1. Nebengruppe des Periodensystems, Elementen der 6. Nebengruppe des Periodensystem, Elementen der 7. Nebengruppe des Periodensystems und der 8. Nebengruppe des Periodensystem besteht.

8. Schaltungselement nach Anspruch 7, bei dem das Metall aus der Gruppe ausgewählt wird, die aus Fe, Co, Cr, Mb, Mn, Ru, und Mo besteht.

9. Schaltungselement nach einem der Ansprüche 5 bis 8,
bei dem die redoxaktive Einheit eine Organometall-Verbindung oder eine anorganische Koordinations-Verbindung ist.

10. Schaltungselement nach einem der Ansprüche 5 bis 8,
bei dem die mindestens eine als Elektronendonator und als Elektronenakzeptor dienenden Gruppe ein Komplex-Ligand des Metallzentrums ist.

11. Schaltungselement nach Anspruch 9 oder 10,
bei denen die anorganische Koordinations-Verbindung ein einkerniger Molybdän-Komplex mit zwei mehrfach gebundenen Chalkogen-Liganden und chelatisierenden Bisphosphin-Liganden oder ein zweikerniger Chrom-Komplex mit verbrückenden α-Metalla-carboxylaten als Liganden ist.

12. Schaltungselement nach einem der Ansprüche 5 bis 9,
bei dem das Metallzentrum an einen im wesentlichen planaren macrocylischen, ein konjugiertes π-Elektronensystem aufweisenden mehrzähnigen Liganden gebunden ist.

13. Schaltungselement nach Anspruch 12,
bei dem der macrocyclische mehrzähnige Ligand Phthalocyanin, Naphthalocyanin, Tetrazaphorphyrin oder ein Derivat davon ist.

14. Schaltungselement nach einem der Ansprüche 5 bis 13,
bei dem die redoxaktive Einheit kovalent oder koordinativ an das Molekülgerüst der elektrisch aktiven Moleküle gebunden ist.

15. Schaltungselement nach einem der vorhergehenden Ansprüche,
bei dem die elektrisch aktiven Moleküle auf dem mindestens einen Bereich aus dem ersten elektrisch leitenden Material über eine Ankergruppe immobilisiert sind, die aus der Gruppe ausgewählt wird, die aus -SH, -COOH, CONH₂, COSH, -OCN, -NCO, - CN, -S-SH, -NR₂, -PR₂, -SiRₓCl₃₋ₓ (mit x= 0,1,2), wobei R für einen beliebigen geeigneten Substituenten, vorzugsweise für Wasserstoff, Alkyl, Aryl oder Arylalkyl steht, besteht.

16. Schaltungselement nach einem der vorhergehenden Ansprüche,
bei dem zusätzlich elektrisch inerte Moleküle auf dem mindestens einen diskreten Bereich aus dem ersten elektrisch leitenden Material immobilisiert sind.

17. Schaltungselement nach einem der vorhergehenden Ansprüche,
bei dem auf der ersten Schicht aus dem elektrisch isolierenden Substratmaterial elektrisch inerte Moleküle immobilisiert sind, die eine Matrix ausbilden, die den mindestens einen diskreten Bereich mit der monomolekularen Schicht aus redox-aktiven Molekülen umgibt.

18. Schaltungselement nach einem der vorhergehenden Ansprüche,
bei dem eine Vielzahl diskreter Bereiche aus dem ersten elektrisch leitenden Material in das Substratmaterial eingebettet und/oder auf dem Substratmaterial aufgebracht ist.

19. Schaltungselement nach einem der vorhergehenden Ansprüche,
bei dem das erste elektrisch leitfähige Material Gold oder Silber ist.

20. Schaltungselement nach einem der vorhergehenden Ansprüche, bei dem die Schicht aus dem zweiten elektrisch leitfähigen Material Gold, Titan, und/oder Aluminium aufweist.

21. Schaltungselement nach einem der vorhergehenden Ansprüche, bei dem die zweiten Schicht mit dem zweiten elektrisch leitfähigen Material derart gestaltet ist, dass das zweite elektrisch leitfähige Material als diskrete Bereiche auf einer Schicht aus einem Isolatormaterial angeordnet und/oder oder in die Schicht aus Isolatormaterial eingebettet ist.

22. Schaltungselement nach einem der vorhergehenden Ansprüche,
bei dem das erste elektrisch leitende Material und das zweite elektrisch leitende Material als Elektroden ausgestaltet sind.

23. Schaltungselement nach Anspruch 22,
das ein Speicherelement ist.

24. Verfahren zur Herstellung eines Schaltungselements, bei dem
• eine Schicht aus einem isolierenden Substratmaterial vorgelegt wird,
• ein erstes elektrisch leitfähigen Material an mindestens einer diskreten Position in das Substratmaterial eingebettet und/oder auf dem Substratmaterial aufgebracht wird,
• zum Transport von Ladungsträgern befähigte Moleküle als monomolekulare Schicht auf dem mindestens einen diskreten Bereich aus dem ersten elektrisch leitfähigen Material immobilisiert werden,
• wobei jedes zum Transport von Ladungsträgern befähigte Molekül der monomolekularen Schicht aufweist
a) eine redox-aktive Einheit, mittels welcher ein veränderbarer Widerstand gebildet ist,
b) mindestens eine erste als Elektronendonator dienende Einheit, und
c) mindestens eine zweite als Elektronenakzeptor dienende Einheit, wobei mittels des Elektronendonators und mittels des Elektronenakzeptors eine Diode gebildet ist, und wobei in jedem Molekül die redox-aktive Einheit zwischen der als Elektronendonator und der als Elektronenakzeptor dienenden Einheit angeordnet ist, und
• eine zweite Schicht mit einem zweiten elektrisch leitfähigen Material auf die Schicht mit den redoxaktiven Molekülen aufgebracht wird, wodurch die redoxaktiven Moleküle der monomolekularen Schicht mit dem zweiten elektrischen Material der zweiten Schicht in Kontakt treten.

25. Verfahren nach Anspruch 24,
bei dem nach der Immobilisierung der zum Transport von Elektronen befähigten Moleküle elektrisch inerte Moleküle auf der ersten Schicht aus dem elektrisch isolierenden Substratmaterial immobilisiert werden, wodurch die elektrisch inerten Moleküle eine Matrix ausbilden, die den mindestens einen Bereich mit der monomolekularen Schicht mit den redoxaktiven Molekülen umgibt.
